# EUROPEAN PATENT SPECIFICATION

(11) **EP 0 852 354 B1**
(45) Date of publication and mention of the grant of the patent: **03.09.2003**
(21) Application number: 97119988.0
(22) Date of filing: 14.11.1997
(51) Int. Cl.: G06F 11/267

(54) **Improvements in or relating to integrated circuit**
Integrierte Schaltung
Circuit intégré

(30) Priority: 25.11.1996 US 31757 P
(43) Date of publication of application: 08.07.1998
(73) Proprietor: TEXAS INSTRUMENTS INCORPORATED, Dallas, Texas 75243 (US)
(72) Inventor: Whetsel, Lee D., Allen, TX 75002 (US)
(74) Representative: Holt, Michael

(56) References cited:
- WO-A-93/04427
- US-A- 5 065 090
- WHETSEL L: "IMPROVED BOUNDARY SCAN DESIGN" PROCEEDINGS OF THE INTERNATIONAL TEST CONFERENCE (ITC), WASHINGTON, OCT. 21 - 25, 1995, 21 October 1995, INSTITUTE OF ELECTRICAL AND ELECTRONICS ENGINEERS, pages 851-860, XP000552888
- SUSHEEL CHANDRA ET AL: "CROSSCHECK: AN INNOVATIVE TESTABILITY SOLUTION" IEEE DESIGN & TEST OF COMPUTERS, vol. 10, no. 2, 1 June 1993, pages 56-64, 65 - 68, XP000369673
- HULVERSHORN H ET AL: "LINKING DIAGNOSTIC SOFTWARE TO HARDWARE SELF TEST IN TELECOM SYSTEMS" PROCEEDINGS OF THE INTERNATIONAL TEST CONFERENCE (ITC), WASHINGTON, OCT. 21 - 25, 1995, 21 October 1995, INSTITUTE OF ELECTRICAL AND ELECTRONICS ENGINEERS, pages 986-993, XP000552906

## Description

### Field of the Invention

The invention relates generally to integrated circuits and, more particularly, to test and emulation in integrated circuits having multiple embedded core circuits therein.

### Background of the Invention

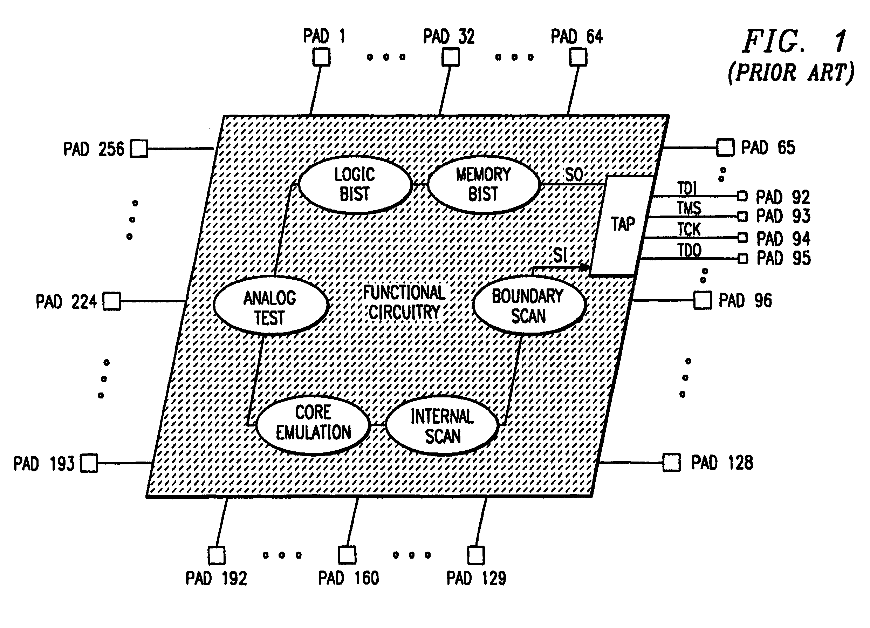

Integrated circuits (IC's) are conventionally designed with test and functional circuits blended together into one common circuit. Using this approach, test circuitry typically requires an undesirably large portion of the IC circuit area, thus disadvantageously reducing the area available for functional circuitry. Figure 1 shows 256 bond pads used to access a functional circuit of an IC, which functional circuit may have embedded therein multiple cores such as microprocessors, digital signal processors, ROM and RAM. For simplicity power/ground pads are not shown. A conventional IEEE STD 1149.1 test access port (TAP) is included in the IC of Figure 1. The TAP is used for scan access of various illustrated test/emulation circuits which are blended with the functional circuit and could occupy 15-20% of the available area.

It is therefore desirable to provide an approach which reduces the amount of circuit area needed for test/emulation circuitry, particularly in multi-cored integrated circuits.

The present invention provides an integrated circuit architecture where most of the test circuit is separate from the functional circuit. The only test circuits required to be blended into the functional circuit are referred to herein as test points. The test points are located at strategic points within the functional circuitry to allow testing. Typically, test points will be located at the boundaries of all well defined digital and analog circuit cores. The test points will provide for testing of the interconnect between circuit cores and for testing of the circuit cores themselves. Due to their simple design, test points do not affect the performance of functional circuits as much as scan cells. The majority of the test circuit of the invention resides as a separate structure referred to as a test access grid. The test access grid provides a common framework for all types of ICs and its architecture is independent of the functional circuit with which it will be used. The test access grid allows for digital and analog test access to come directly from the pads of the IC and/or from scan cells located within the test access grid. The test access grid is connected to the test points in the functional circuit by a test routing layer. Each unique functional circuit will have a customized routing through the test routing layer to couple the test points in the functional circuit to the standardized test access grid.

The present invention further provides an integrated circuit with bond pad-selectable I/O. The invention further provides an integrated circuit having a stand-alone embedded scan resource. The invention further provides an integrated circuit having signal collectors and a bond pad arrangement that maximises bond pad access to the signal collectors.

US 5 064 090 discloses a test architecture comprising a set of probe lines extending across an integrated circuit and a set of sense lines extending across the integrated circuit in a perpendicular direction. Each sense line can be connected via respective switches to a plurality of circuit nodes to be tested. The sense lines provide test data to the test nodes or receive test data from them. When a probe line is activated it connects selected ones of the test nodes to the sense lines, one per sense line. The sense and probe lines either terminate at special pads located on the wafer in the spaces between individual integrated circuits or at respective stages of a shift register.

According to the present invention in one aspect thereof, there is provided an integrated circuit as claimed in claim 1.

### Brief Description of the Drawings

The present invention will now be further described, by way of example, with reference to the accompanying drawings in which:
Figure 1 illustrates a conventional integrated circuit having test and emulation circuitry blended with its functional circuitry;
Figure 2 illustrates a pad isolation feature according to the present invention;
Figures 3 and 3A illustrate an integrated circuit according to the present invention having a functional circuitry, a test routing layer, and a test access grid as three separate conceptual layers of circuitry;
Figure 4 illustrates the test access grid of Figure 3 in greater detail;
Figure 5 illustrates digital scan cells connected to the grid lines of Figure 4;
Figure 5A illustrates the digital scan cells of Figure 5 in greater detail;
Figure 5B illustrates a control circuit of Figure 5A in greater detail;
Figure 6 shows analog and digital scan cells connected to the grid lines of Figure4;
Figure 6A illustrates the analog scan cells of Figure 6 in greater detail;
Figure 6B illustrates the a control circuit of Figure 6A in greater detail;
Figure 6C illustrates in greater detail the analog test interface of Figure 6;
Figures 7A-7F illustrate various possible configurations of the digital scan cells, analog scan cells and analog test interface in the scan path of Figure 6;
Figure 8 illustrates conceptually the test routing layer connections between the grid lines of the test access grid and embedded test points in the functional circuitry;
Figures 9A-9E illustrate various ways that digital circuitry can be accessed using the test access grid;
Figures 10A-10E illustrate various ways that analog circuitry can be accessed using the test access grid;
Figures 11A-11D illustrate various ways that analog-to-digital circuitry can be accessed using the test access grid;
Figures 12A-12D illustrate various ways that digital-to-analog circuitry can be accessed using the test access grid;
Figure 13 illustrates boundary scan cells and electrostatic discharge protection circuitry in combination with the pads and conceptual circuit layers of Figure 3 and the test access port and analog test interface of Figure 6;
Figure 13A illustrates in greater detail the electrostatic discharge protection circuitry of Figure 13;
Figure 13B illustrates how the electrostatic discharge protection circuitry of Figure 13A can be used when interfacing integrated circuits having different power supply voltages;
Figure 13C illustrates an arrangement for controlling a plurality of the electrostatic discharge protection circuits of Figure 13A;
Figure 14 illustrates plural groups of test points embedded within the functional circuitry, each group connected to a respective grid line of the test access grid;
Figures 15-15B illustrate a conventional scan design for testing digital circuit cores in integrated circuits;
Figure 16 illustrates input test points and output test points connected to circuit cores within the integrated circuit and to the test access grid to permit testing the circuit cores via the test access grid;
Figure 16A illustrates in greater detail the input test point of Figure 16;
Figure 16B illustrates in greater detail the output test point of Figure 16;
Figure 16C illustrates in greater detail the bus holder circuit of Figure 16A;
Figure 17 illustrates external test points connected between circuit cores of an integrated circuit and also connected to the test access grid for permitting testing of the circuit cores;
Figure 17A illustrates the external test point of Figure 17 in greater detail;
Figure 18 illustrates another external test point connected between circuit cores of the integrated circuit and connected to the test access grid;
Figure 18A illustrates the external test point of Figure 18 in greater detail;
Figures 19 and 19A illustrate a conventional scan cell design used for testing cores having bi-directional digital signal lines;
Figure 20 illustrates bi-directional test points connected to circuit cores and connected to the test access grid for testing circuit cores having bi-directional signal lines;
Figure 20A illustrates the bi-directional test point of Figure 20 in greater detail;
Figure 21 is similar to Figure 20 but illustrates an alternate embodiment of a bi-directional test point;
Figure 21A illustrates the bi-directional test point of Figure 21 in greater detail;
Figure 22 illustrates bi-directional test points, input test points and output test points arranged to permit a master circuit core and a plurality of slave circuit cores to be accessed via the test access grid;
Figure 22A illustrates in greater detail the interconnection between the input test points and the bi-directional test points of Figure 22;
Figure 23 illustrates conceptually the I/O programmability of the pad switches of Figure 4 to permit pad access to the slave circuit cores of Figure 22;
Figure 24 illustrates an arrangement which permits a plurality of nodes in the functional circuitry to be monitored via the test access grid;
Figures 25A-25C conceptually illustrate various modes of accessing an analog circuit using the structures illustrated in Figures 4 and 6;
Figures 26A-26D illustrate various modes of accessing combinational logic using the structures of Figures 4-6;
Figure 27 illustrates the manner in which a given node of a functional circuit can be monitored using the monitor probe of Figure 24 and the scan path of Figure 6;
Figure 28 illustrates the manner in which a node of a functional circuit can be monitored using the analog scan cell and analog test interface of Figure 6 in combination with the monitor probe of Figure 24;
Figure 29 illustrates a plurality of input and output test points connected to the test access grid to provide core access via the pad switches of Figure 4 and the scan path of Figure 6;
Figures 30 and 30A illustrate that a plurality of mutually connected test point groups can share routing through the test routing layer;
Figures 31 and 31A illustrate that a plurality of mutually connected monitor probe groups and test point groups can share routing in the test routing layer;
Figure 32 illustrates emulation of an embedded, internally scannable core according to the present invention;
Figure 33 illustrates an embedded test controller which can be selectively substituted for the test access port to control the scan paths utilized by the present invention;
Figure 33A illustrates circuitry in the test access port of Figure 33 which permits selection of and communication with the embedded test controller of Figure 33;
Figure 34 is a block diagram of the embedded test controller of Figure 33;
Figure 35 illustrates the structure and operation of the scan resource of Figure 34;
Figure 36 illustrates the structure and operation of the BIST resource of Figure 34;
Figure 36A illustrates the test controller of Figure 36 in greater detail;
Figure 36B is a state diagram of the state machine of Figure 36A;
Figure 37 illustrates the structure and operation of the analog resource of Figure 34; and
Figure 38 illustrates an arrangement of power supply pads and TAP pads in an integrated circuit according to the present invention.

### DETAILED DESCRIPTION OF THE INVENTION

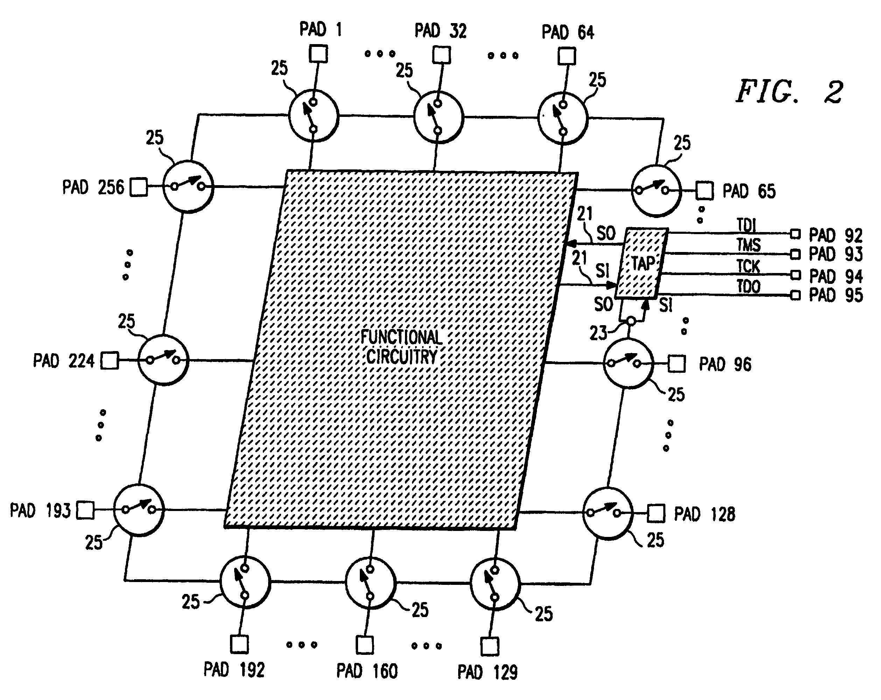

In Figure 2, a conventional capture-shift-update (CSU) type scan cell 23 is shown that is accessible from the TAP and provides control to the isolation elements 25. Isolation elements 25 could be, for example, 3-state buffers or transmission gates controlled from scan cell 23. Thus, the TAP can be used to isolate all pads from the functional circuitry. Also, the TAP can access internal scan cells within the functional circuit, via a scan path 21 of the TAP.

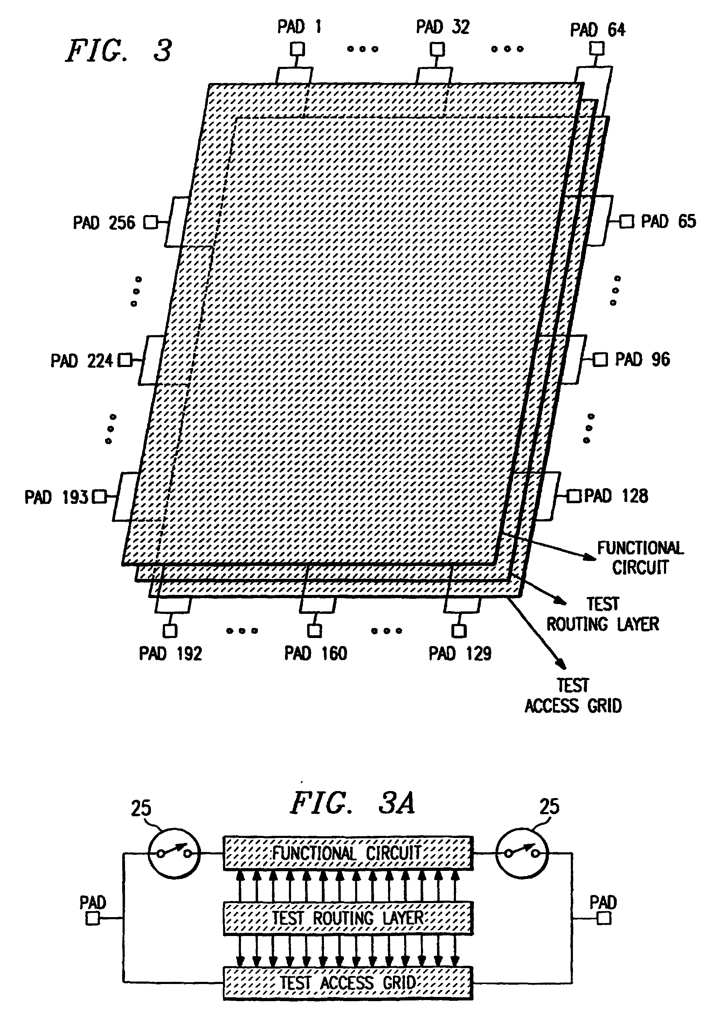

Figures 3 and 3A show the functional circuit, a test routing layer, and a test access grid conceptually as three separate layers of circuitry. The test routing layer provides connectivity between the functional circuit and the test access grid. The test access grid provides pad and/or scan test access to the functional circuit, via the test routing layer. The pads are connected to the functional circuit by isolation elements 25, and are also connected to the test access grid. Note that Figures 3 and 3A are only conceptual diagrams for clarity. The grid and functional circuit, can be but need not be separate metal levels or layers in the IC, and the test routing layer can be but need not be embodied as vias between metal levels. The conceptual structures shown in Figure 3A can be physically realized in whatever manner is advantageous to the overall IC design.

All scan paths disclosed herein are preferably implemented as conventional Test Data Registers as described in IEEE STD 1149.1, including conventional capture-shift-update (CSU) type scan cells as described in IEEE STD 1149.1. The conventional TAP control inputs provided to the Test Data Registers from the TAP Controller and Instruction Register are described in IEEE STD 1149.1 and are designated herein as CTL.

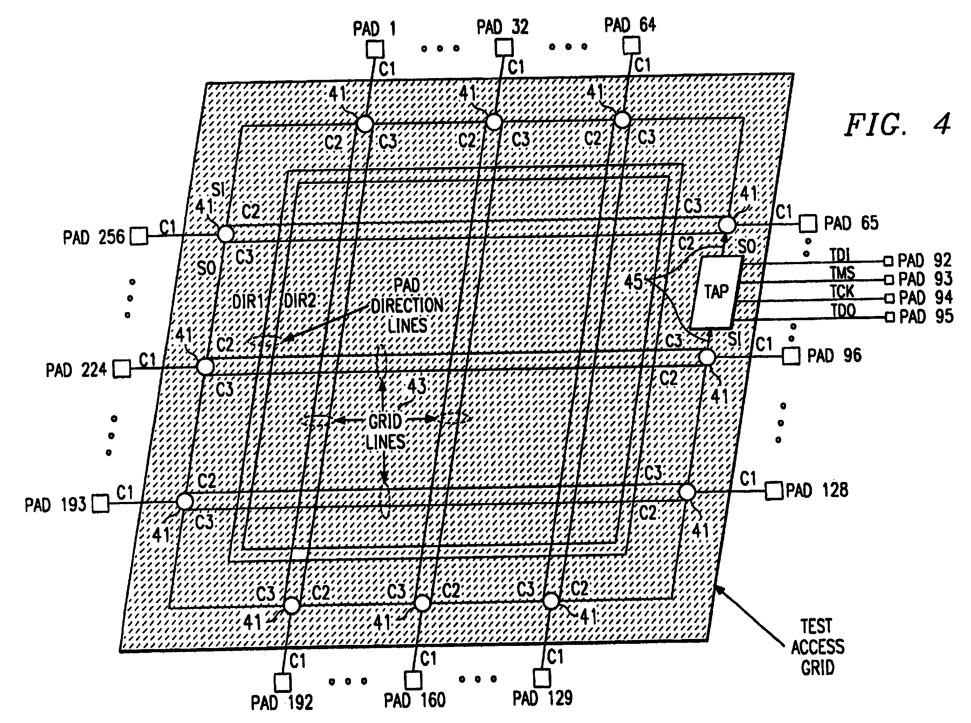

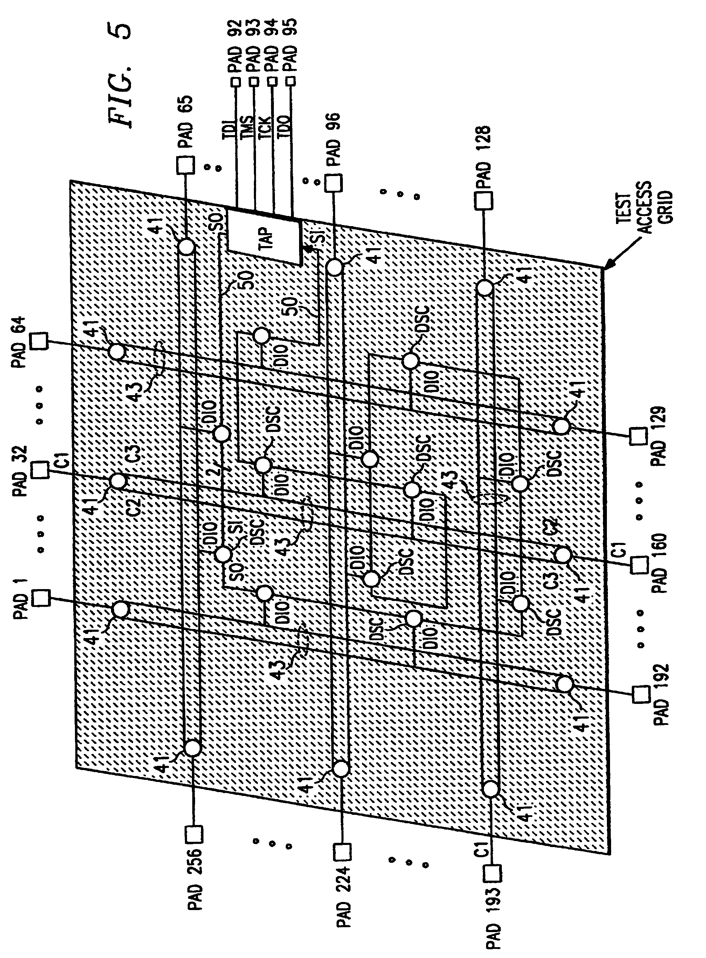

Figure 4 shows the test access grid and a first part of its structure. This first part includes; (1) a TAP for serial test access using IEEE STD 1149.1, (2) pad switches 41 connected to each pad, (3) conductive grid line pairs 43 which define the test access grid and extend between opposite pads and pad switches, and (4) one or more direction (DIR1 and DIR2) lines routed around the test access grid. While the functional circuit is in normal (non-test) operation, the pad switches isolate the pads from the grid lines and isolation elements 25 allow functional I/O through the pads. In test mode, the functional I/O is disabled by isolation elements 25, and the pad switches 41 can be enabled to connect the grid lines to the pads for test I/O.

The pad switches have three signalling terminals; C1, C2 and C3. The C1 terminal is connected to the pad, and the C2 and C3 terminals are connected to the pair of grid lines such that C2 of one pad switch is connected to C3 of the opposite pad switch. The pad switches also have terminals for scan input (SI), scan output (SO), and scan control (CTL). The scan path 45 is routed through conventional capture-shift-update (CSU) scan cells in the pad switch and through a control circuit. The pad switch also has a direction input which allows the pad switch to operate as an I/O, and a programming output. The programming outputs are decoded from the scan cells in the control circuit and make connections either between the pad switch C2 output and DIR1/DIR2 lines or between the DIR1/DIR2 lines and the direction input to the pad switch. 3-state buffers make the connections between the pad switch 41 and DIR1/DIR2 lines in response to the programming outputs. Buffers can be enabled together to connect C2 to both DIR1 and DIR2. This and any other desired combination of enabled and/or disabled buffers can be easily achieved by adding CSU's to the control circuit and modifying the decoder appropriately.

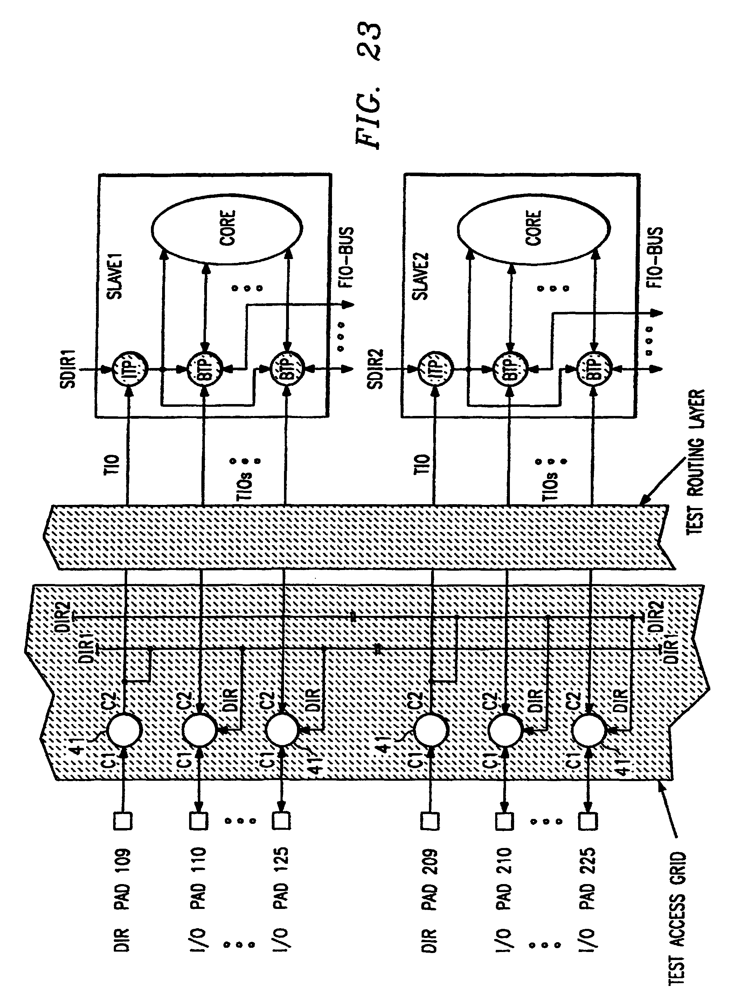

The CSU's regulate the input, output, I/O or disconnect configuration of the pad switch. If the pad switch is configured as an input, data appearing at the pad is transmitted from terminal C1 through the pad switch to the C2 terminal which is coupled to a grid line. If the pad switch is configured as an output, data appearing on the grid line coupled to the C2 terminal is transmitted through C1 to the pad. If the pad switch is configured for I/O operation, the DIR terminal regulates the input or output operation of the pad switch. The decode of the programming output allows a pad switch to be used as a DIR control for a bank of other pad switches which are used for bussed I/O to functional cores. More description of using pad switches for bussed I/O will be given in reference to Figure 23. The C2 to C3 terminal connection between pad switches allows testing the continuity of the grid lines in the test access grid. For example, signals output on the C2s of pads 128 and 193 can be respectively verified at pads 193 and 128.

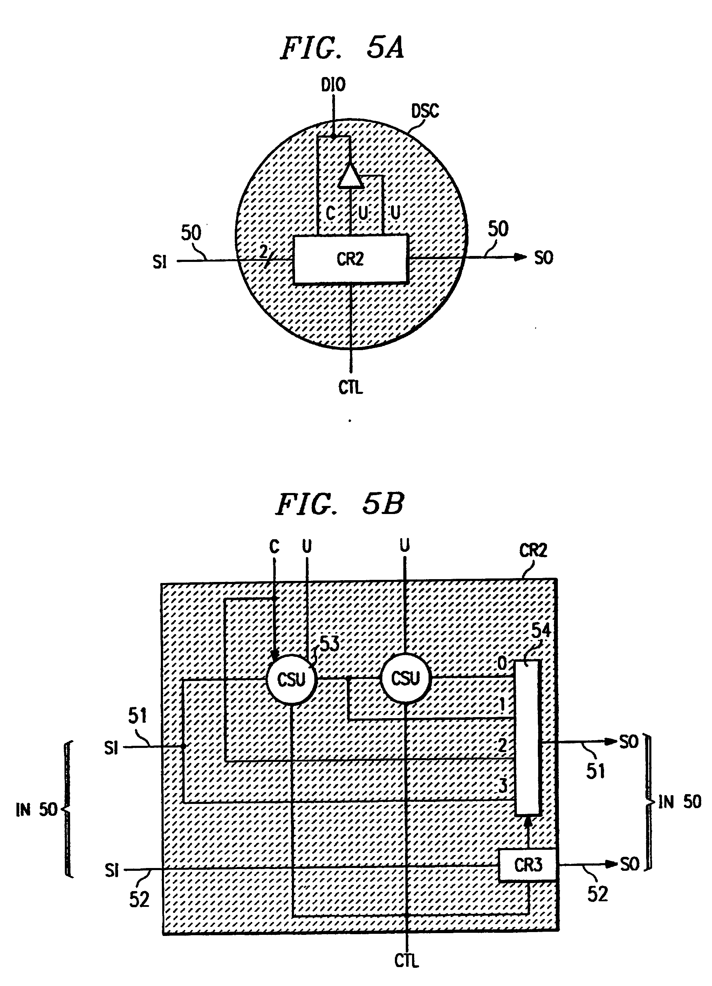

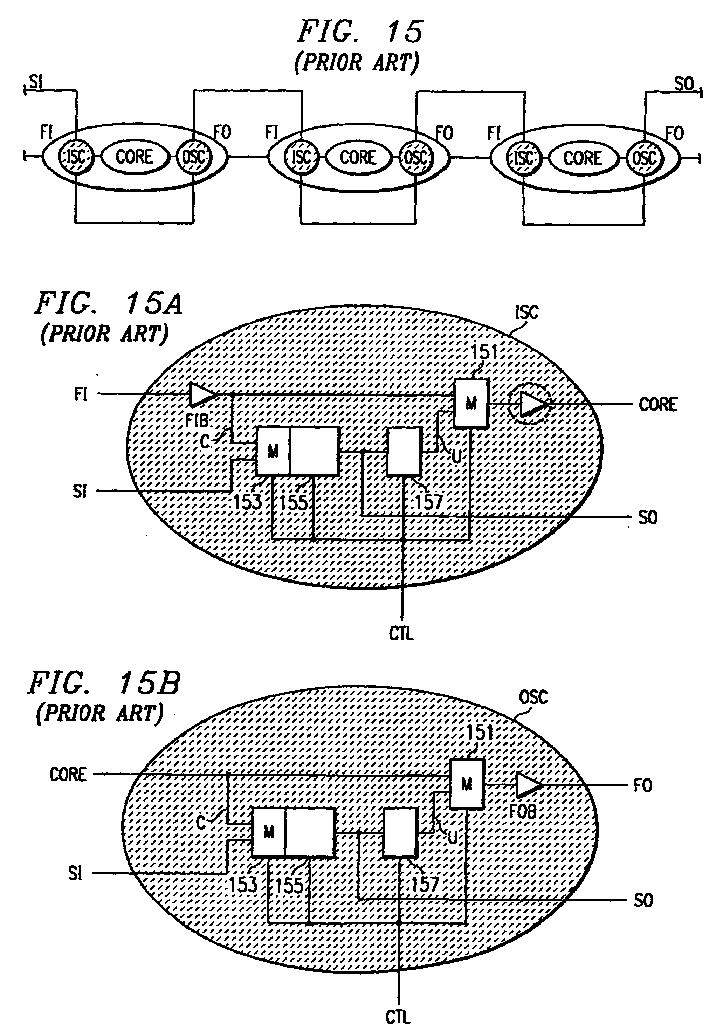

Figures 5-5B show a second part of the test access grid. This second part includes placement of a digital scan cell (DSC) on each grid line. The DCSs are connected to the TAP via a pair of scan paths at 50 to allow shifting data to and from the DSCs. Each DSC can control the grid line to which it is attached to a logic 1, logic 0, or 3-state condition (Figure 5A). The DSC includes a 3-state I/O at DIO which is controlled by a scannable control circuit (CR2) in scan path pair 50. As shown in CR2 of Figure 5B, scan path pair 50 includes two separate scan paths 51 and 52 through which serial data flows through the DSC from SI to SO. The scan path 52 passes through a control circuit (CR3) which is used to configure the scan path 51. The scan path 51 includes two CSU's that control the 3-state I/O at DIO. The scan path 51 can be configured by CR3 and multiplexer 54 so that data from SI to SO flows through both CSUs, only one CSU 53, or directly from SI to SO. Additionally, the scan path 51 can be configured so that data from the DIO flows directly out of SO. The capture/shift memory in the CSU, and the update outputs of the CSUs (designated U) are provided from respective update memories in the respective CSUs. Conventional capture/shift and update memories are shown in Figure 15A at 155 and 157, respectively. The capture input of capture/shift memory 155 is labelled C and the update output of update memory 157 is labelled U. CR3 can include two CSUs in scan path 52 to select the four possible configurations of multiplexer 54. When CSU(s) in scan path 51 is (are) bypassed, the multiplexer control output from CR3 that selects the bypass configuration is preferably used to gate off the capture, shift and update control (in CTL) of each bypassed CSU so that the CSU maintains its state from the time of bypass selection.

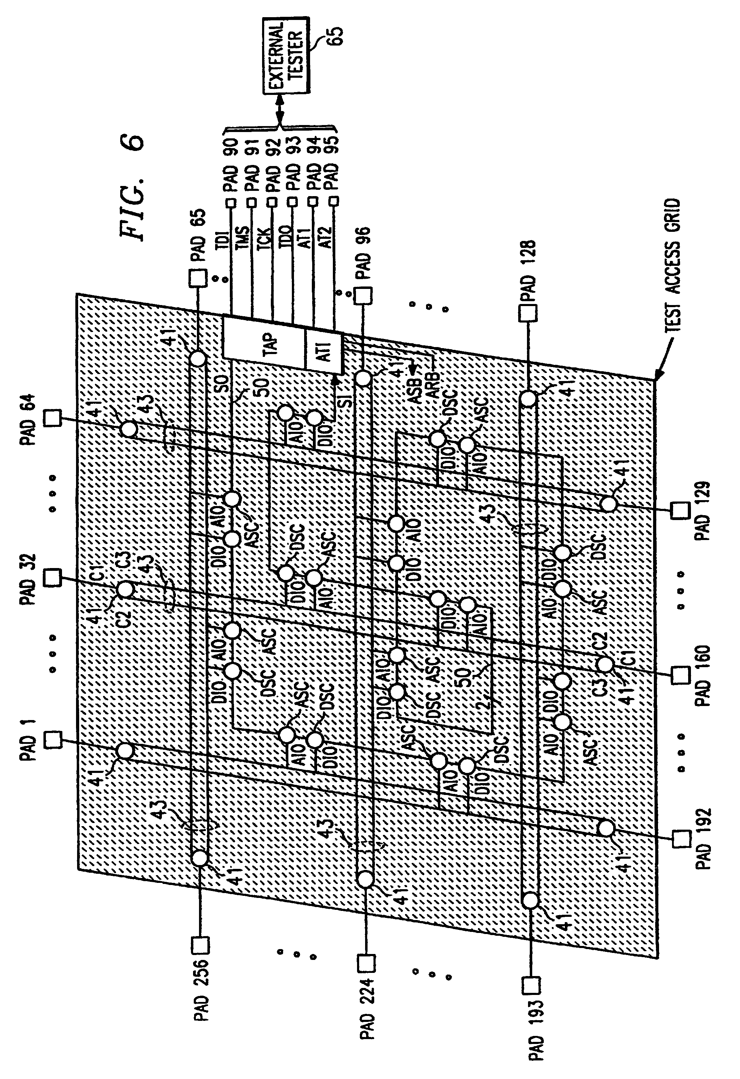

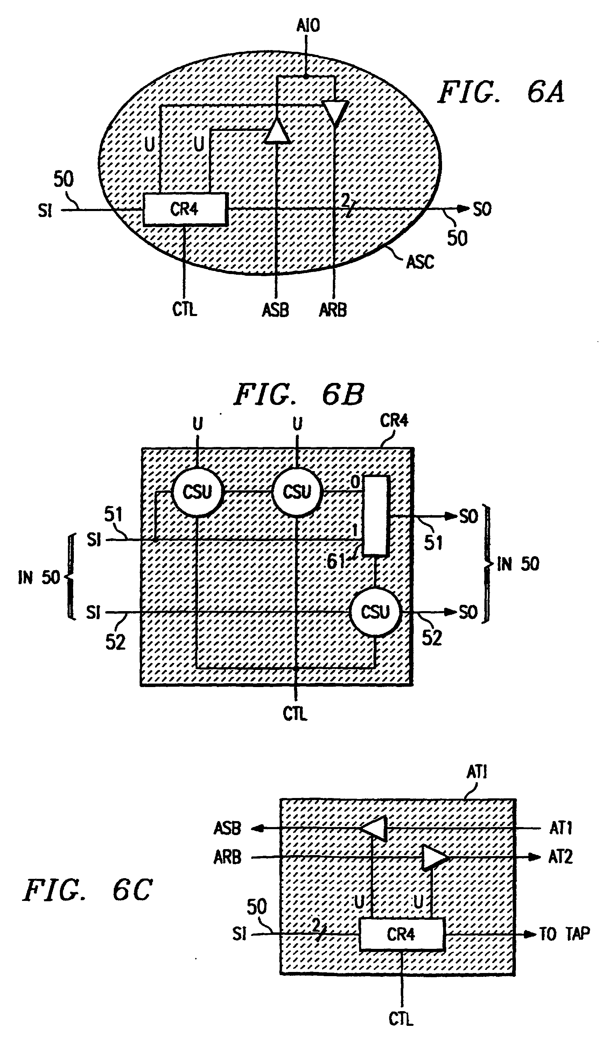

Figures 6-6C show a third part of the test access grid. This third part includes placement of an analog scan cell (ASC) on each grid line. The ASCs are placed on the same scan path pair 50 as the DSCs to allow data to be shifted through both cell types simultaneously. Each ASC is also connected to an analog stimulus bus (ASB in Figure 6A) and an analog response bus (ARB in Figure 6A). These analog buses are connected to an analog test interface (ATI) connected to bond pads for analog input (AT1) and output (AT2). AT1 and AT2 are being defined by IEEE STD P1149.4 to input/output analog signals to test functional circuitry. Although any two pads could be defined for input/output of analog test signals, it may be advantageous to utilize the AT1 and AT2 pads of the 1149.4 standard as shown in Figure 6C.

As seen in Figure 6C, the ATI has a control circuit (CR4) which can enable/disable the AT1/AT2 pins from the ASB/ARB of the ASCs. Also the ASC has a CR4 that can make or break a connection between ASB/ARB and the grid line coupled to the ASC at AIO. In the ASC, scan path 52 is used with multiplexer 61 to configure the operation of the scan path 51 (Figure 6B). The scan path 51 is used to make/break the connection between the AIO and ASB/ARB. In one configuration of the scan path 51 (see also Figure 6A), the data from SI to SO flows through the two CSUs that control the grid line connection to ASB/ARB via the 3-state analog I/O at AIO. In the other configuration, the data from SI flows directly to SO. When CSUs are bypassed in Figure 6B, the multiplexer control can be used to gate off CTL at the bypassed CSUs, in the manner described above relative to Figure 5B.

During configuration scans, data from the TAP flows through the scan path (configuration path) 52 to all DSCs/ASCs so that all cell configurations occur at the same time. During data scans, data from the TAP flows through the configured scan path (data path) 51 to all DSCs/ASCs.

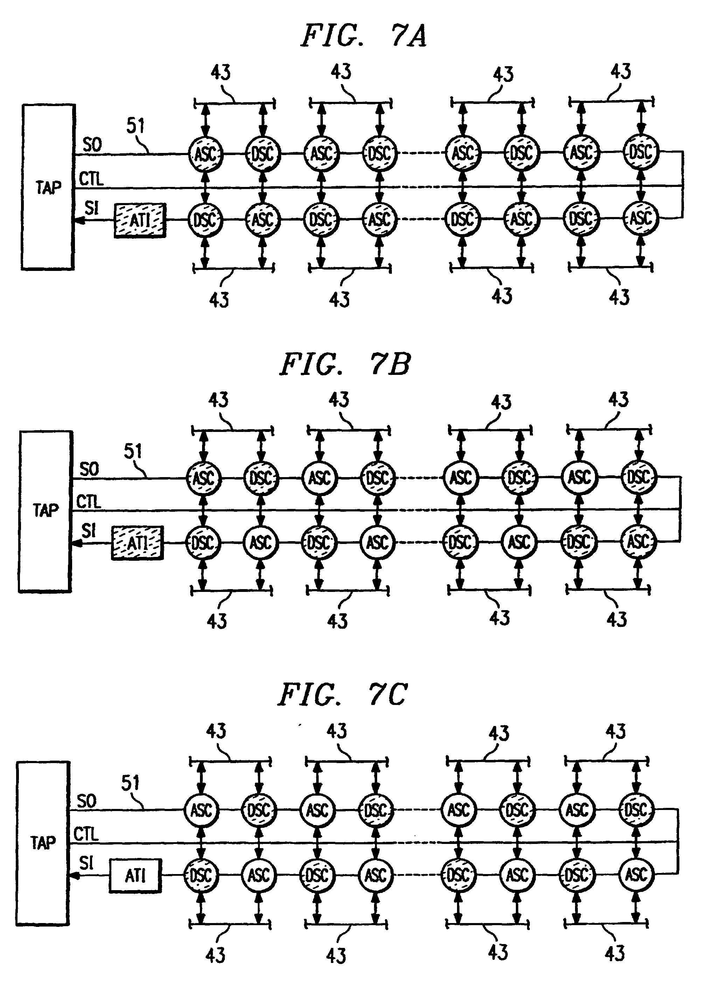

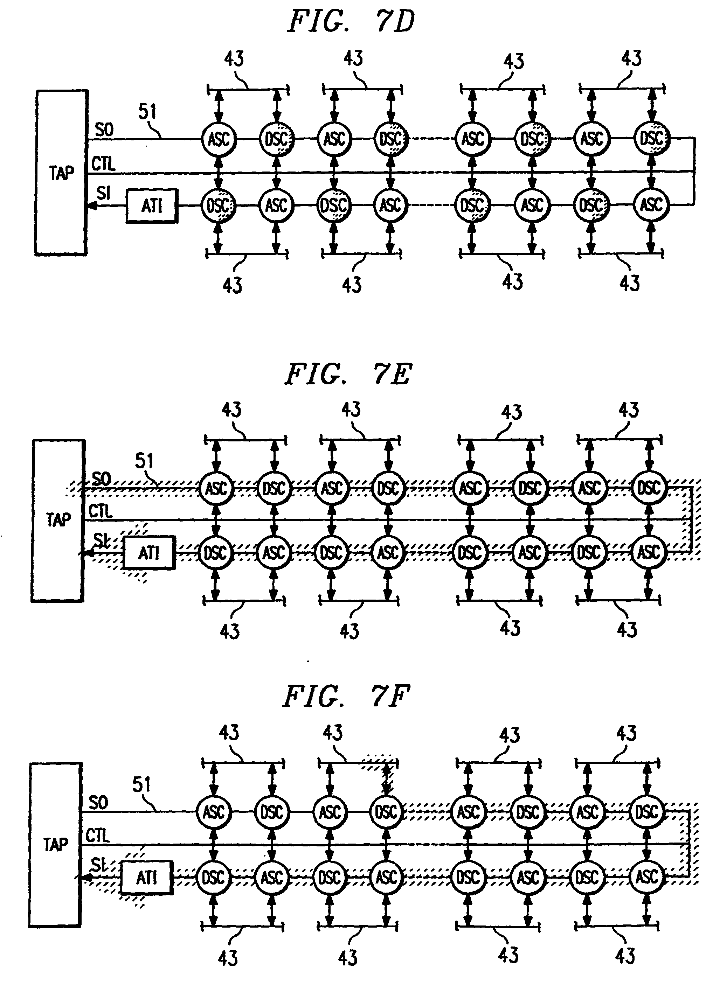

Figures 7A-7F illustrate various configurations of the data scan path 51. Figure 7A shows a configuration where all CSUs of the DSCs and ASCs and the ATI scan data from the TAP. Figure 7B shows a configuration where all CSUs of the DSCs and the ATI scan data but only the CSUs of the two shaded ASCs are selected to scan data, the remaining unshaded ASCs having their CSUs bypassed. Figure 7C shows a configuration where all CSUs of the ASCs and the ATI are bypassed while all CSUs of the DSCs scan data. Figure 7D shows a configuration where all CSUs of the ASCs and the ATI are bypassed, and only the CSUs 53 of the DSCs (Figure 5B) scan data. This is shown by half-shading in the DSCs. Figure 7E shows a configuration where all CSUs of the DSCs, ASCs, and ATI are bypassed and data from the TAP flows directly through each cell in the scan path. Figure 7F shows a configuration where the data on a selected grid line passes directly through the associated DSC (see Figures 5A-5B), and through other DSC/ASC pairs whose CSUs are bypassed, to be input to the TAP.

Figure 7A represents the test access grid scan path configuration when scan testing involves all DSCs/ASCs and the ATI. Figure 7B represents the test access grid scan path configuration when testing involves only two ASCs, the ATI and all DSCs. Figure 7C represents the test access grid scan path configuration when testing only involves the DSCs. Figure 7D represents the test access grid scan path configuration when only the CSUs 53 of each DSC are in the scan path. Figure 7E represents the ability for all cells to be bypassed and for data entering the TAP on TDI to flow through the scan path cells and exit the TAP via TDO (see TAP in Figure 6) to provide a connectivity test. Figure 7F represents the ability of a selected DSC to allow the data on its grid line to pass directly therethrough and then through bypassed cells and ATI to be output from the TAP's TDO, which permits functional data associated with a grid line to be monitored at TDO in real time.

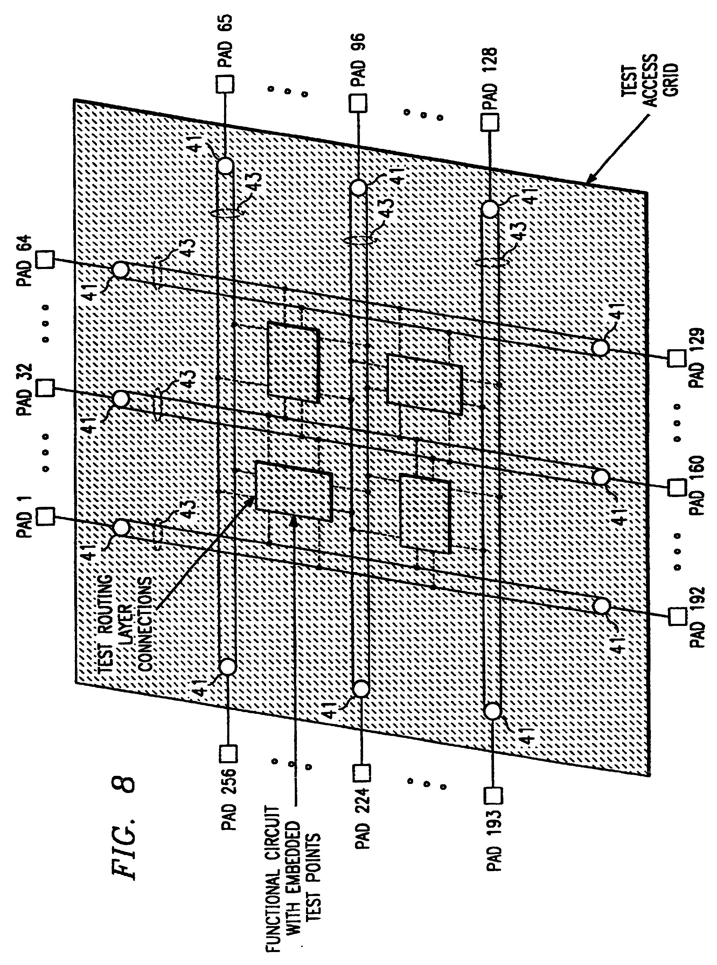

Figure 8 illustrates conceptually the connections made by the test routing layer (Figures 3-3A) between the functional circuits of the IC and the grid lines of the test access grid. Each functional circuit will include embedded test points. The test routing layer serves as the interconnect between these test points and the grid lines. The grid lines extend substantially entirely across the IC and serve as collectors/distributors of test and emulation signals. The test points embedded in the functional circuitry are preferably connected to the most easily accessible grid line in order to minimize the routing complexity in the test routing layer between the functional circuitry and the test access grid. In many instances, the most easily accessible grid line will be the nearest adjacent grid line, so that two cores located relatively far apart in the IC may have test points connected to the same grid line because it is the nearest adjacent grid line to both cores. Signals supplied by the IC pads and/or by DSC/ASC are distributed by the associated grid line to the test routing layer for routing to the desired test points, and signals from the desired test points are collected from the test routing layer by the grid line and provided at the pads and/or DSC/ASC.

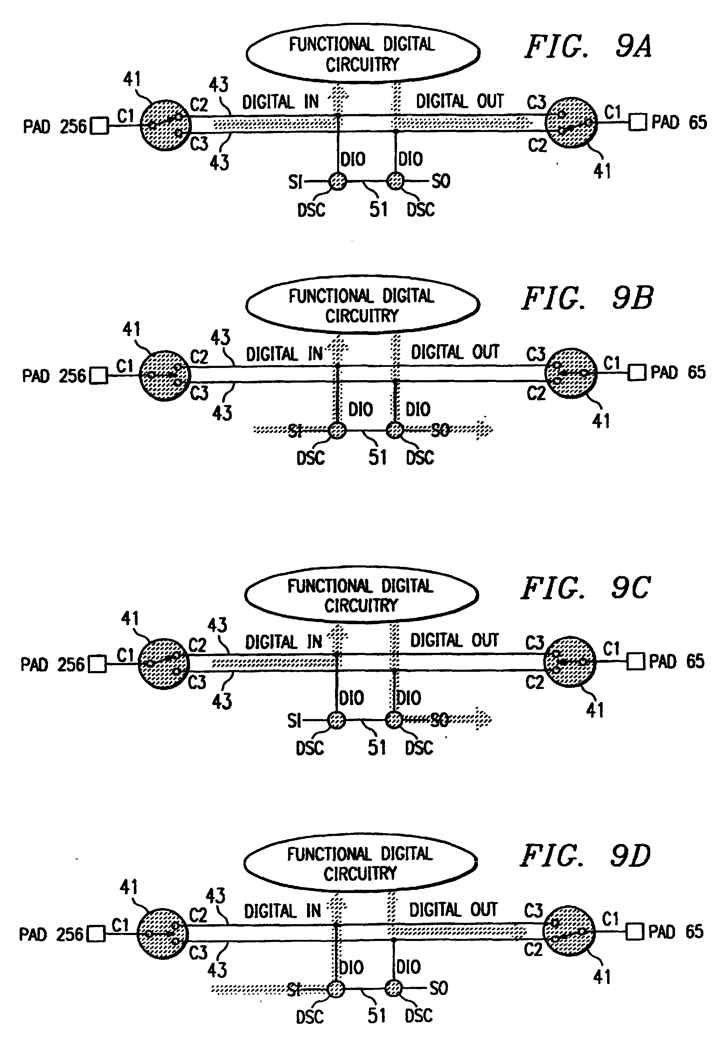

Figures 9A-9E show various test access configurations wherein functional digital circuitry and the test access grid are connected by the test routing layer. Figure 9A shows the pad switches of the test access grid providing test input and output paths to the digital circuitry via the IC pads. Figure 9B shows the DSCs of the test access grid scan path 51 providing test input and output paths to the digital circuitry. Figure 9C shows a configuration where pad switches provide test input and DSCs of the scan path provide test output. Figure 9D shows the opposite configuration of Figure 9C. Figure 9E shows the ability of the DSCs to provide on-line monitoring of digital circuitry (see also Figure 7F) while the digital circuitry is in normal functional mode (note the pads are isolated from the grid lines).

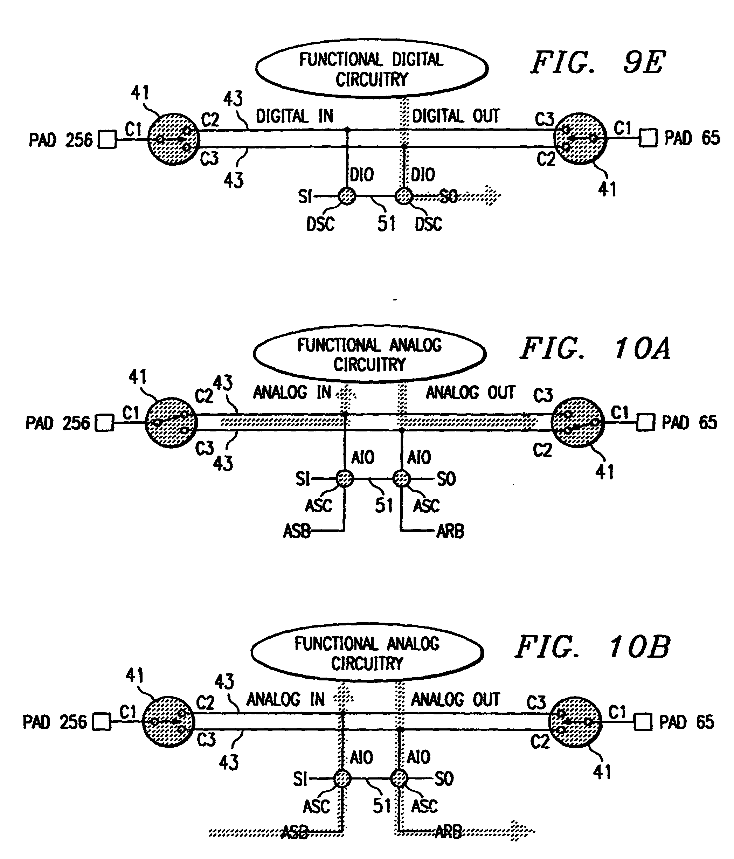

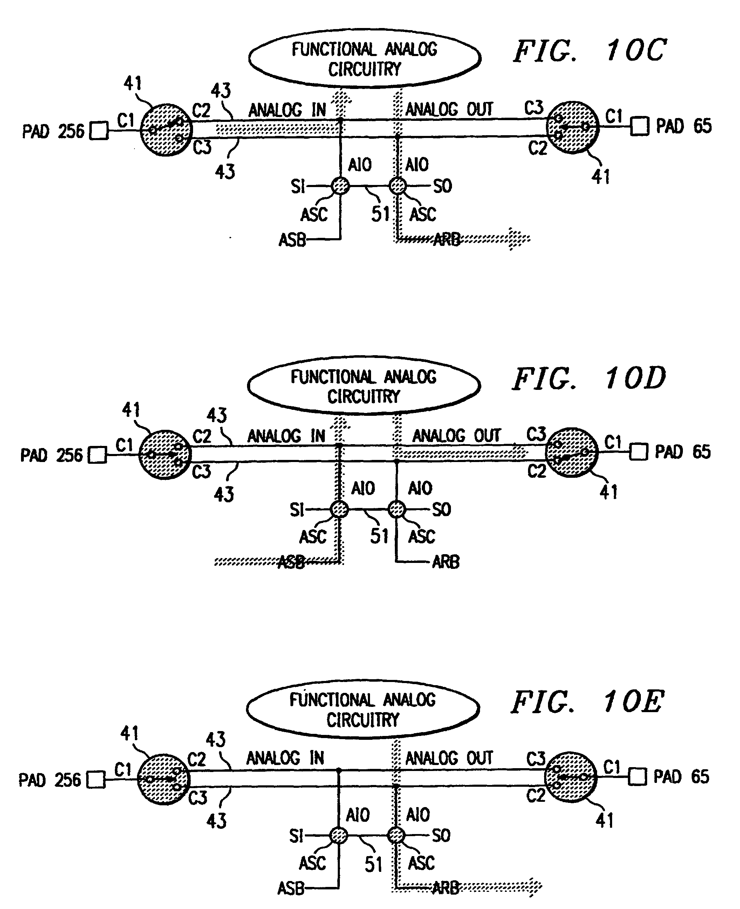

Figures 10A-10E are similar to Figures 9A-9E and show the various test access configurations wherein functional analog circuitry and the test access grid are connected by the test routing layer. Figure 10A shows the pad switches of the test access grid providing test input and output paths to the analog circuitry via the IC pads. Figure 10B shows the ASCs of the test access grid scan path 51 providing test input and output paths to the analog circuitry. Figure 10C shows a configuration where pad switches provide test input and ASCs provide test output. Figure 10D shows the opposite configuration of Figure 10C. Figure 10E is similar to Figure 9E and shows the ability of the ASCs to provide on-line monitoring of analog circuitry while the analog circuitry is in normal functional mode.

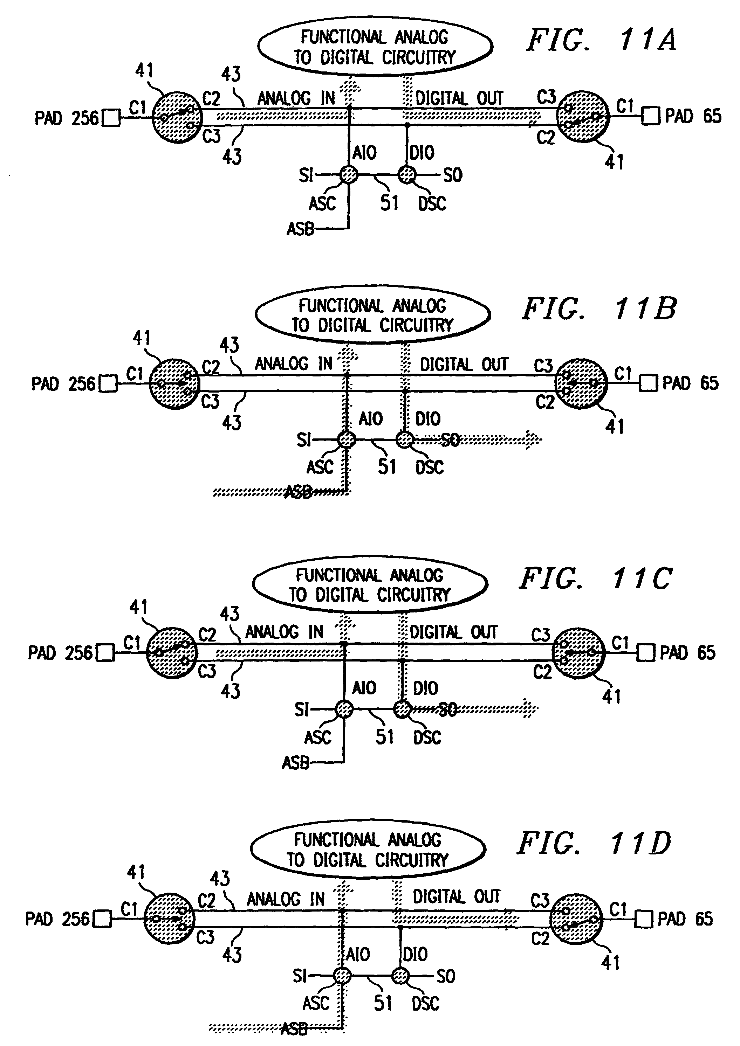

Figures 11A-11D illustrate test configurations when using the test access grid to test an A/D converter circuit. Figure 11A shows an A/D receiving analog stimulus through pad switches and outputting digital response through pad switches. Figure 11B shows the A/D receiving analog stimulus from the ASB input to an ASC and outputting digital response through DSCs. Figure 11C shows the A/D receiving analog stimulus through pad switches and outputting digital response through DSCs in the scan path. Figure 11D shows the A/D receiving analog stimulus from the ASB input to an ASC and outputting digital response through pad switches.

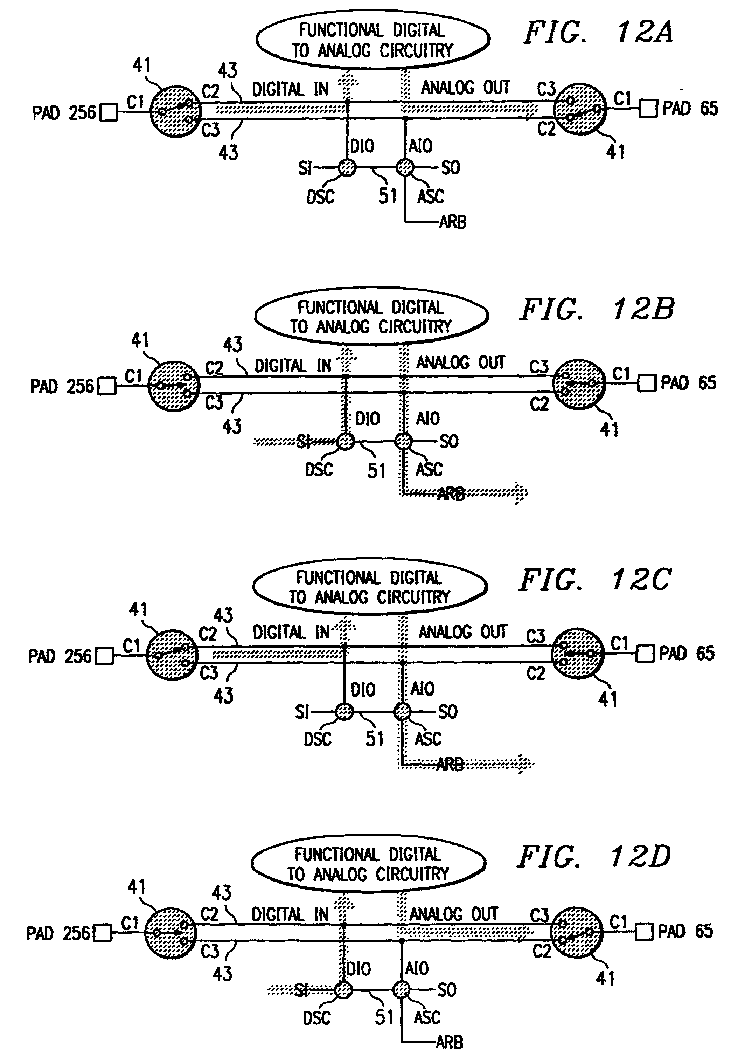

Figures 12A-12D illustrate test configurations when using the test access grid to test a D/A converter circuit. This is similar and analogously opposite to the description given for Figures 11A-11D.

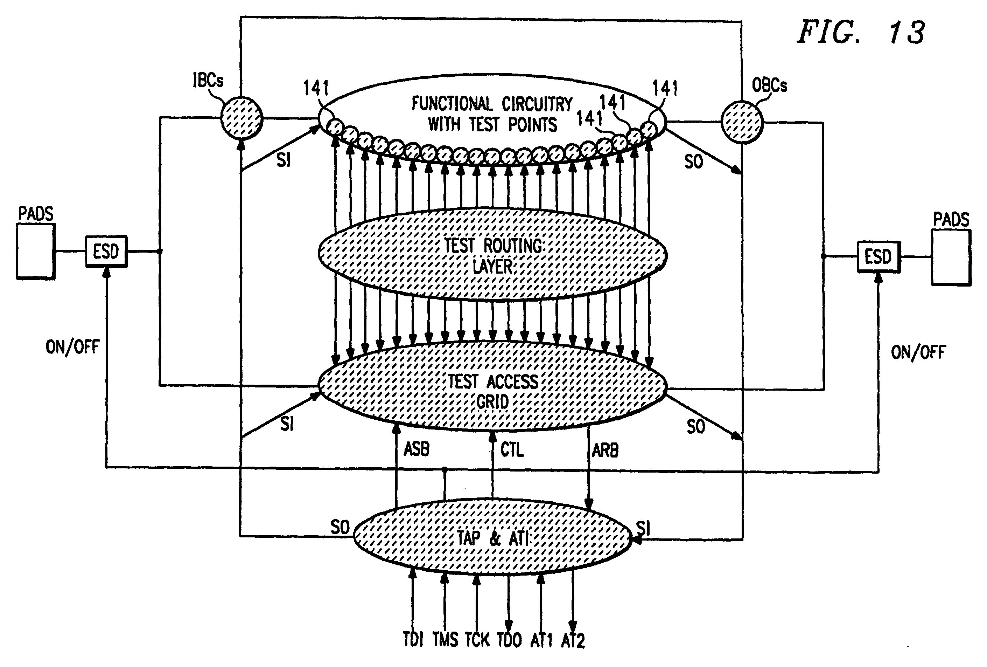

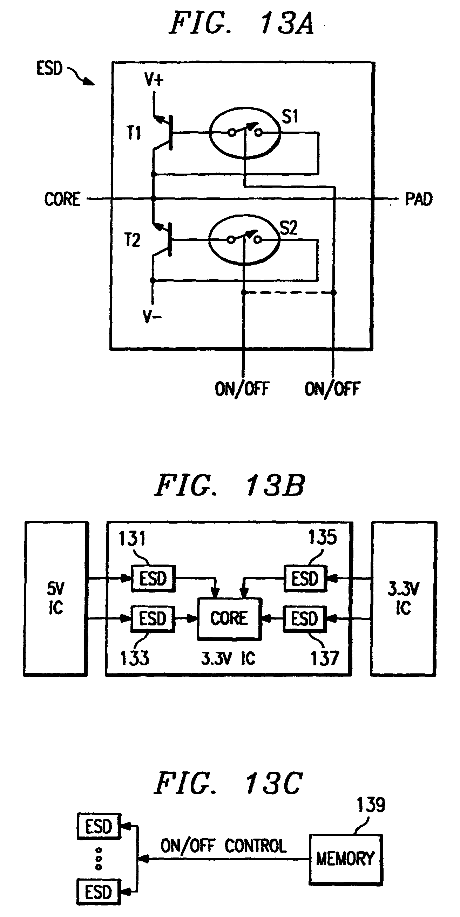

Figure 13 shows components of the invention in more detail. The TAP and ATI have an external interface to the IEEE 1149.1/P1149.4 six-pin test bus. The TAP and ATI are interfaced to the test access grid, to test points 141 in the functional circuitry, and to conventional boundary scan cells such as IBC (input cell) and OBC (output cell). The test routing layer interfaces test points in the functional circuitry to the grid lines of the test access grid. The pads are connected to both the functional circuitry and to the test access grid, as also shown in Figure 3. In the Figure 13 arrangement, the boundary scan cells can be used to isolate the pads, instead of the Figure 2 isolation arrangement. Each boundary scan cell would control in a conventional manner the selective isolation of its pad from the functional circuitry.

To enable analog circuit testing to occur from pad switches associated with digital pins, the ESD circuitry of digital pins is disabled during test. Typically ESD circuitry exists, as shown in Figure 13, on all pins of an IC to prevent damage from voltage spikes. Traditional ESD circuitry clamps or limits the pin voltage between some predetermined high and low level. To adequately test analog circuits in a mixed signal IC, a digital pin may be required to input or output voltage levels beyond the clamp limits of its ESD circuitry.

To allow for larger input or output voltages on pins during analog testing, an ESD circuit is provided for use at IC pins. The ESD circuit, shown in Figure 13 on an input pin and an output pin, can selectively provide or not provide an ESD pin voltage clamping function. As shown in example Figure 13A, the ESD circuit includes two transistors T1 and T2, and two switches S1 and S2. The emitter of T1 is connected to the upper, V+ limit, the base of T1 is connected, via S1, to the collector of T1, and the collector of T1 is connected to the pin wire. The collector of T2 is connected to the lower, V- limit, the base of T2 is connected, via S2, to the collector of T2, and the emitter of T2 is connected to the pin wire. S1 and S2 are switches (pass transistors/transmission gate) that can be controlled, by an On/Off signal, to either make or break the base-to-collector connections of T1 and T2. If the base-to-collector connections are made, T1 will conduct current between the pin wire and V+ when the pin wire voltage goes above V+, providing the high level ESD pin clamp limit. Likewise, T2 will conduct current between V- and the pin wire when the pin wire voltage goes below V-, providing the low level ESD pin clamp limit. In this mode, T1 and T2 operate as would conventional ESD clamping diodes between the pin wire and V+ and V-. If the base-to-collector connections are broken, T1 and T2 are prevented from conducting current between the pin wire and V+ and V-, and thus the ESD clamping function is disabled.

Figure 13, the On/Off control to the ESD circuits is shown coming from the TAP, for example from a scan path controlled from the TAP. The TAP outputs On when the IC is in functional mode, and the ESD circuitry behaves conventionally. The TAP outputs are Off when the IC is in test mode, and the ESD circuitry is disabled from clamping the voltage inputs so that, for example, higher or lower than normal voltage levels (but still safe levels) can pass in and out of digital pins to test analog circuitry. Digital input and output buffers (not shown) of pads used for analog test can be readily designed to tolerate analog test voltages. The ESD On/Off control could come from sources such as IC pins, or scan cells. Each ESD circuit could have an individual On/Off control to each of S1 and S2 as shown, which allows selective enabling or disabling of either the high clamp feature of T1, the low clamp feature of T2, both of the T1 or T2 clamp features, or neither of the T1 and T2 clamp features. To make the ESD circuit have individual selection of high and low clamp features, two separate On/Off signals can be separately provided to S1 and S2. Each ESD On/Off control could be individually regulated by a single control line (for example from a dedicated scan cell) per pin, as shown by broken line in Figure 13A.

The programmable ESD circuit of Figure 13A can also be used when interconnecting ICs that have different supply voltages (i.e. 5V and 3.3V ICs) on board designs. The programmable ESD circuit on pins connected between 5V and 3.3V ICs could be disabled, while the ESD circuit on pins connected between ICs with the same voltage supply could be enabled. This would allow a 5V IC to communicate to a 3.3V IC without invoking the high limit clamping feature of the 3.3V IC and accompanying loading of 5V IC output. Depending on how the IC is used, the programmable ESD circuit can selectively control whether the high, low, or high and low clamping diodes are enabled or disabled on a pin by pin basis.

Figure 13B shows a 3.3V IC interfaced with a 5V IC and another 3.3V IC. ESD circuits 131 and 133 could be programmed with S1 open and S2 open, or with S1 open and S2 closed. Either programming disables the high limit clamping of T1, but the latter programming retains the T2 clamp capability, which is disabled by the former programming. Of course the latter programming requires at least two ON/OFF control signals. ESD circuits 135 and 137 can be programmed with both S1 and S2 closed, because there is no need to disable any clamping.

Figure 13C shows control of a plurality of programmable ESD circuits. The ON/OFF control is retained by a memory circuit 139 connected to the ESD circuits. The memory circuit is loaded from a source external to the IC. For example, externally loaded software could write the control data to a register, or the control information could be loaded into a register from an external hardware source. Memory circuit 139 can be as small as one bit that controls all switches of all ESDs, as large as one bit for every switch, or any size in between, according to how many switches need to be separately controlled.

The ASCs, DSCs, ATI, and pad switches of the test access grid as well as the embedded test points within the functional circuit are preferably designed to tolerate and/or pass any voltage level required to test the functional circuit.

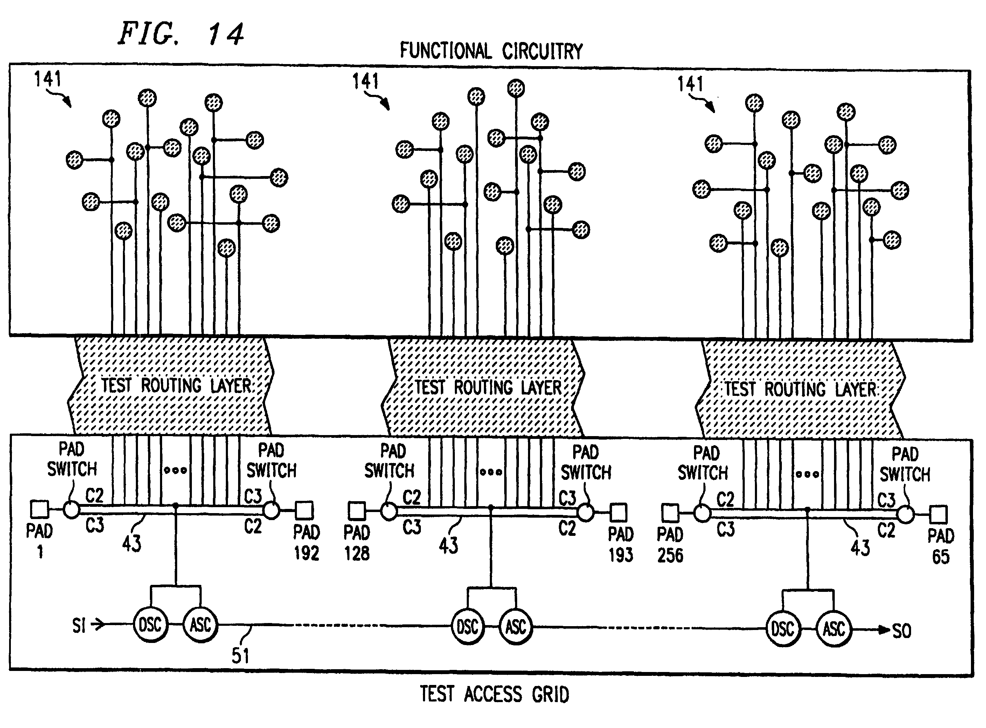

Figure 14 shows grid lines in the test access grid connected to groups of test points 141 in the functional circuit via the test routing layer. The effect of this arrangement is that while each grid line is a single signal path controlled during test by either the pad or one of the scan cells, it actually has the ability to control any number of connected test points in the functional circuit. The test point which is to be controlled by a grid line has to be selected. The selection of a test point occurs by scanning the test points to enable one or more of them to operate with the grid line during test. All grid lines are similarly connected to various test point groups. Each test point can isolate the grid line from the functional circuit to prevent the grid line load from affecting the performance of the functional circuit. Because each grid line can be connected to plural test points, each DSC and each ASC and each pad can be used to access plural test points. Thus, for example, scan path 51 constitutes a re-usable scan register that can access many different groups of test points.

Figures 15-15B show a conventional example of how scan design is used to test digital circuit cores in ICs. An input scan cell (ISC) is placed on each core input and an output scan cell (OSC) is placed on each core output. The term "core" as used herein can mean any type of circuit within the overall functional circuit. For example, a core could indicate a simple combinational logic block, a memory, or a complete digital signal processor. During normal operation the scan cells are transparent and data flows in and out of the cores through the scan cell multiplexer 151 (Figures 15A-15B). In test mode, the scan cells isolate the cores, via the multiplexer 151, and allow them to be tested individually by the scan cell's multiplexer 153, capture/shift memory 155 and update memory 157. One test possible with the Figure 15 arrangement is to verify the interconnect between the cores. Another test is to verify the core by scanning input and output test patterns to and from the core. If the core is complex, for example a DSP, an internal scan path may exist within the core in addition to the scan cells placed at the core I/O boundary.

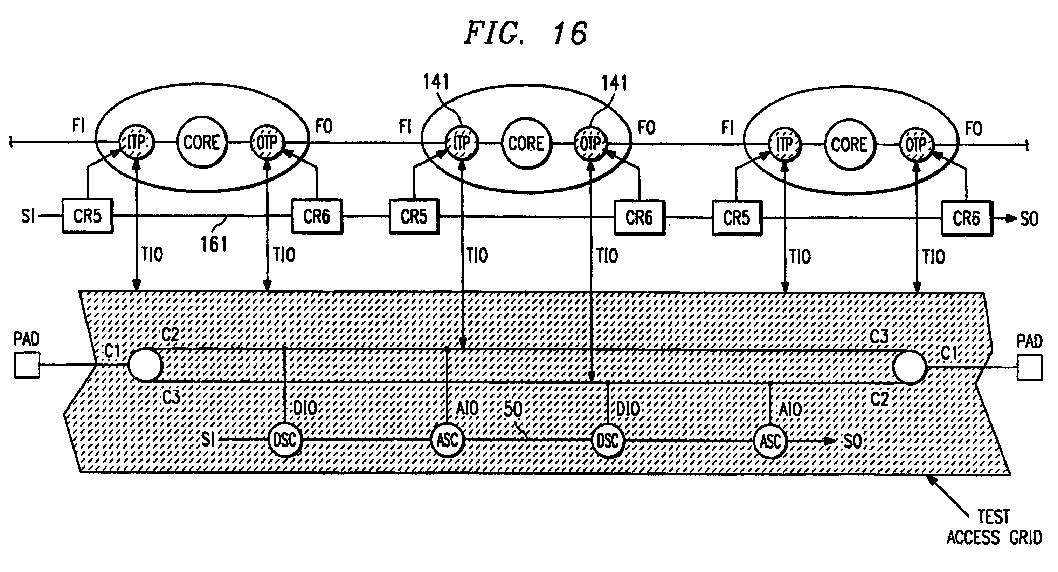

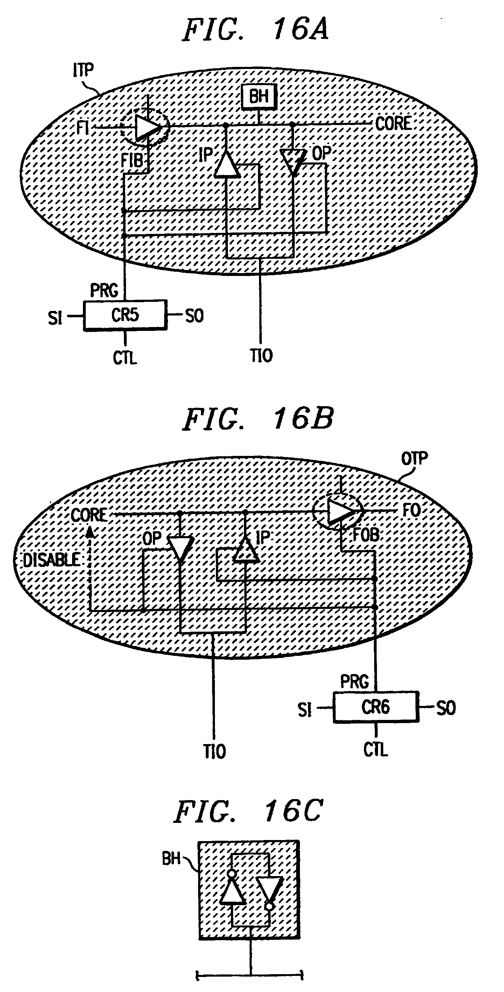

Figures 16-16C illustrate input test points (ITP) and output test points (OTP). The input and output test points ITP and OTP each have a 3-state input buffer (IP) and a 3-state output buffer (OP) respectively connected to their output and input. The input of ITP is designated FI and the output of OTP is designated FO. Functional signals associated with normal IC operation are carried on FI (core input signals) and FO (core output signals). The output of ITP is connected to the associated core as is the input of OTP. The input to the input buffer IP and the output from the output buffer OP are connected as a test input/output (TIO) which is routed to the test access grid via the test routing layer. Circuits CR5 and CR6 have the same structure as CR1 and can be scanned from the TAP and decoded similarly to CR1 to select any one of four test point mode settings; normal, path test, core test, and isolate, as described below.

FIB and FOB are the actual input and output buffers of the core itself, reused here for test and circled in broken line to indicate such reuse. In normal mode, the input and output buffers IP and OP of both test points are disabled and the functional input and output buffers (FIB & FOB) are enabled for normal operation. In path test mode, the FOB of OTP and FIB of ITP are enabled. Also the input buffer IP of OTP and the output buffer OP of ITP are enabled. Further, the output drive from the core to the FOB in OTP is disabled (for example, switched out) by an output from CR6 as indicated by the dashed "Disable" line in Figure 16B. In this setting, test data from the test access grid can be input to the TIO of OTP, passed on to ITP, and returned to the test access grid via the TIO of ITP. This verifies the interconnect between cores. In core test mode, the FOB of OTP and FIB of the ITP are disabled. Also OP of OTP and IP of ITP are enabled. In this setting, test data from the test access grid can be input to the core from the TIO of ITP, and output from the core via the TIO of OTP. This verifies the core circuit. In isolate mode, all three buffers of ITP and OTP are disabled. While in isolation mode, a bus holder (Figure 16C) keeps the data input to the core stable. ITP and OTP of a given core can be placed in isolation mode when other cores are being tested. In isolation mode, all TIOs of the isolated core are disabled from driving the associated grid lines to permit another core's TIOs to drive the grid lines.

One CR5 can control all ITPs and one CR6 can control all OTPs of a given core. The test point overhead is thus basically IP and OP. Also if path testing is not required, OP of ITP and IP of OTP can be eliminated to reduce the test point overhead to a single 3-state buffer per core I/O line. The test data communicated on the test access grid and TIOs can travel via the IC pads and pad switches and/or via the scan path DSCs/ASCs. In the example of Figure 16 it is possible to test multiple cores at the same time, because the three TIO pairs of the three illustrated cores are routed to three different grid line pairs, one of which is shown. However, all three TIO pairs could also be connected to the one illustrated grid line pair.

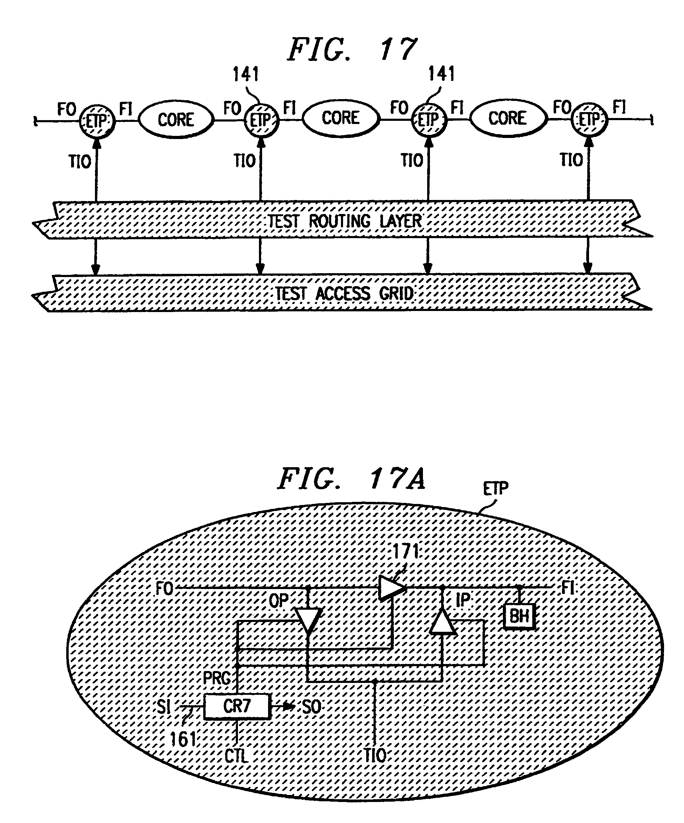

Figures 17 and 17A illustrate external test points (ETP) in the interconnects between cores. The ETP includes a 3-state buffer 171 in the interconnect between FO and FI for core isolation. Also external test points can only operate as a test input or a test output, but not both since only one TIO is provided. The control circuit CR7 has the same structure as CR6 and decodes normal, test input, test output, and isolation modes. In normal mode, OP and IP are disabled and buffer 171 is enabled. In test input mode, IP is enabled and OP and buffer 171 are disabled. In test output mode, OP is enabled and IP and buffer 171 are disabled. In isolation mode, all three buffers of ETP are disabled. A given core can be tested/evaluated by placing the ETP at the core input in test input mode and placing the ETP at the core output in test output mode, and then using the TIOs to provide core stimulus and receive core outputs, the TIOs being accessible via the pad switches or DSCs/ASCs as described above. The ETP approach of Figure 17 may be useful, for example, in situations where a pre-existing core macro cannot be readily provided with ITP and OTP of Figure 16. Also one CR7 can control all external test points associated with common core inputs (such as an input bus) and one CR7 can control all external test points associated with common core outputs (such as an output bus), so the number of CR7 circuits can be limited. If an output bus of one core is connected to an input bus of another core via plural ETPs, then all of the ETPs can be controlled by a single CR7.

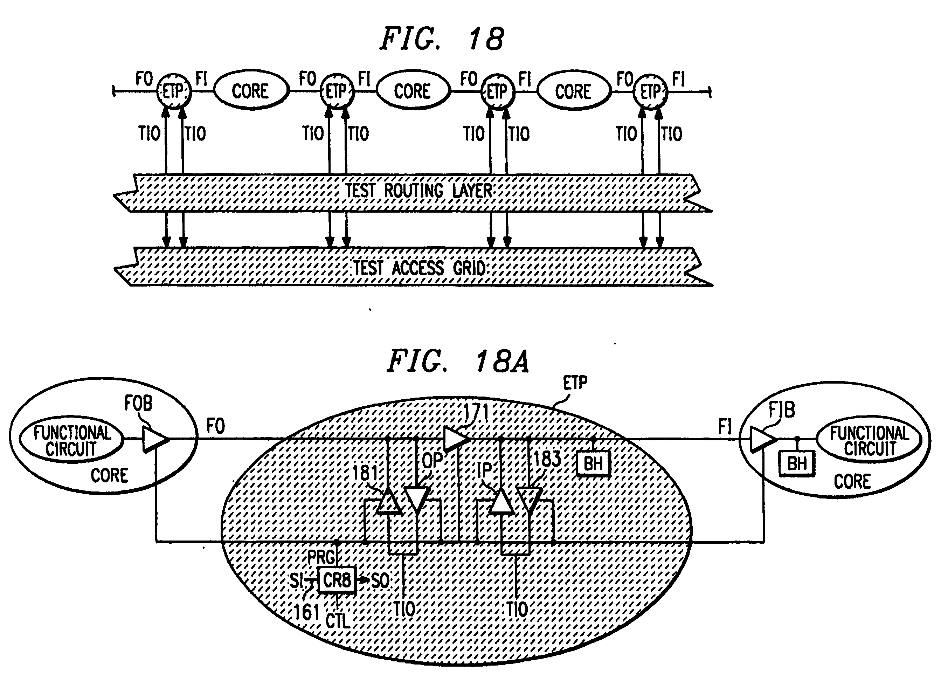

Figures 18 and 18A illustrate an external test point capable of performing path testing between cores and for simultaneous testing of connected cores. Control circuit CR8 is similar to CR7 above, but with decode (PRG) outputs as follows. In normal mode, buffer 171 is enabled and all other buffers of ETP are disabled. In path test mode, buffers 171, 181 and 183 are enabled and OP, IP, FIB, and FOB are disabled. In test input mode, IP is enabled and all other ETP buffers are disabled. In test output mode, OP is enabled and all other ETP buffers are disabled. In test I/O mode, IP and OP are enabled and all other ETP buffers are disabled. In isolate mode, all ETP buffers are disabled. The cores shown in Figure 18 can be simultaneously tested/evaluated by placing all ETPs of Figure 18 in the test I/O mode, and then using the TIO's to provide core stimulus and receive core outputs. A single CR8 circuit can control all external test points associated with common core inputs and a single CR8 can control all external test points associated with common core outputs.

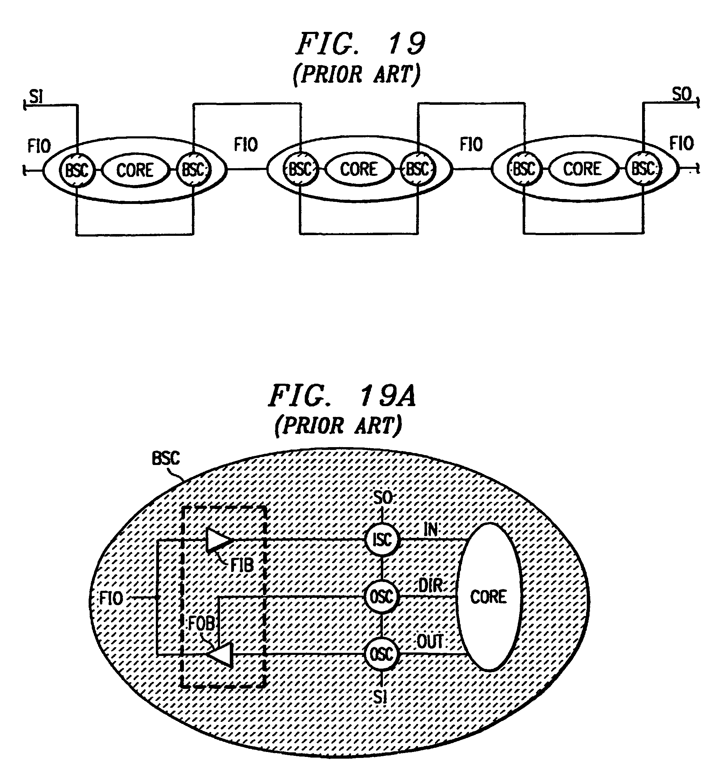

Figures 19 and 19A show a conventional example of how scan cells are used on bi-directional core signals. One OSC outputs, another OSC controls FOB, and an ISC inputs. On a bi-directional bus, only one OSC is required to control all FOBs since all FOBs are controlled together. The operation of ISC and OSC is as described above.

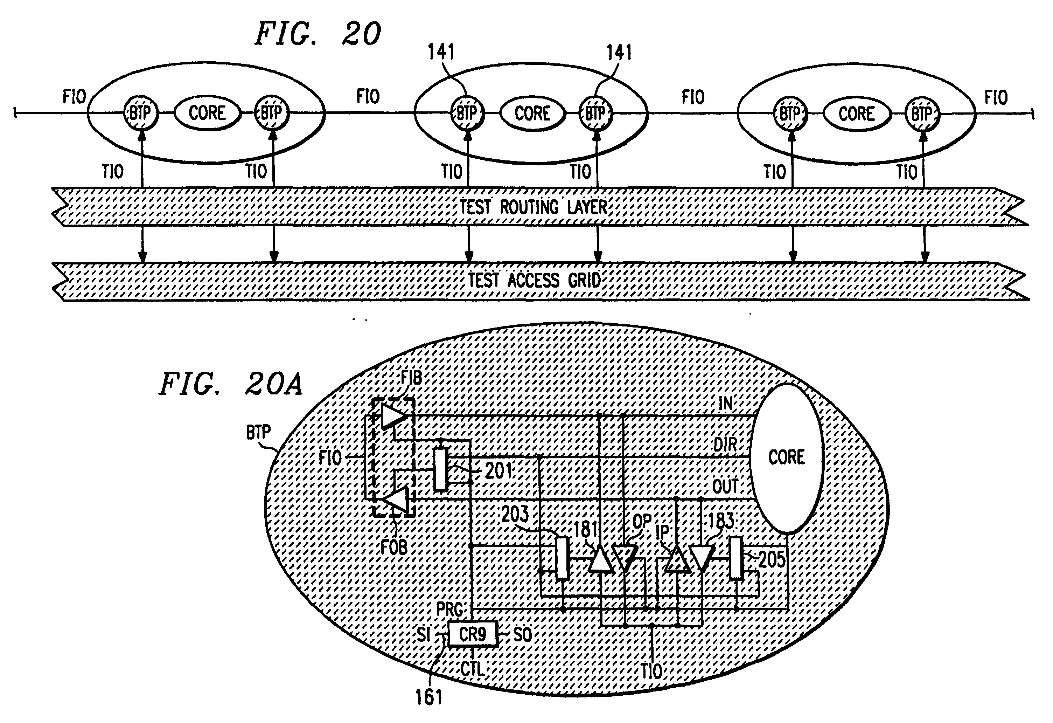

Figures 20 and 20A show bi-directional test points (BTP). In this example, the core generates the direction (DIR) signal which causes functional input or output operation of the bi-directional signal. Also, a single control circuit CR9 can be used to control all bussed BTPs of the same core. Control circuit CR9 is similar to CR8 but with decode outputs (PRG) as follows.

In normal mode, FIB is enabled, DIR controls FOB via multiplexer 201, and all other buffers are disabled by CR9, to allow normal functional operation of the core. During output path test, FOB and IP are enabled by CR9, and the remaining buffers and the core output are disabled by CR9 to allow TIO from the test access grid to be output from FOB. During input path test, FIB and OP are enabled by CR9, and the remaining buffers are disabled by CR9 to pass data received at FIB to the test access grid via TIO. When one BTP is in output path test mode and a connected BTP is in input path test mode, testing of the interconnect between the two can be performed from the test access grid. During core test mode, FIB, FOB, OP and IP are disabled by CR9, and buffers 181 and 183 are controlled by DIR via multiplexers 203 and 205 to input and output data between the core and test access grid via TIO. Test patterns applied to the test access grid can be designed to coordinate with the known operation of the core so that data is input or output to or from TIO when the core is in a corresponding input or output mode. The core in this example could be a microprocessor, and the test access grid communicates with the microprocessor via its bi-directional data bus. In isolate mode, all buffers in Figure 20A are disabled by CR9.

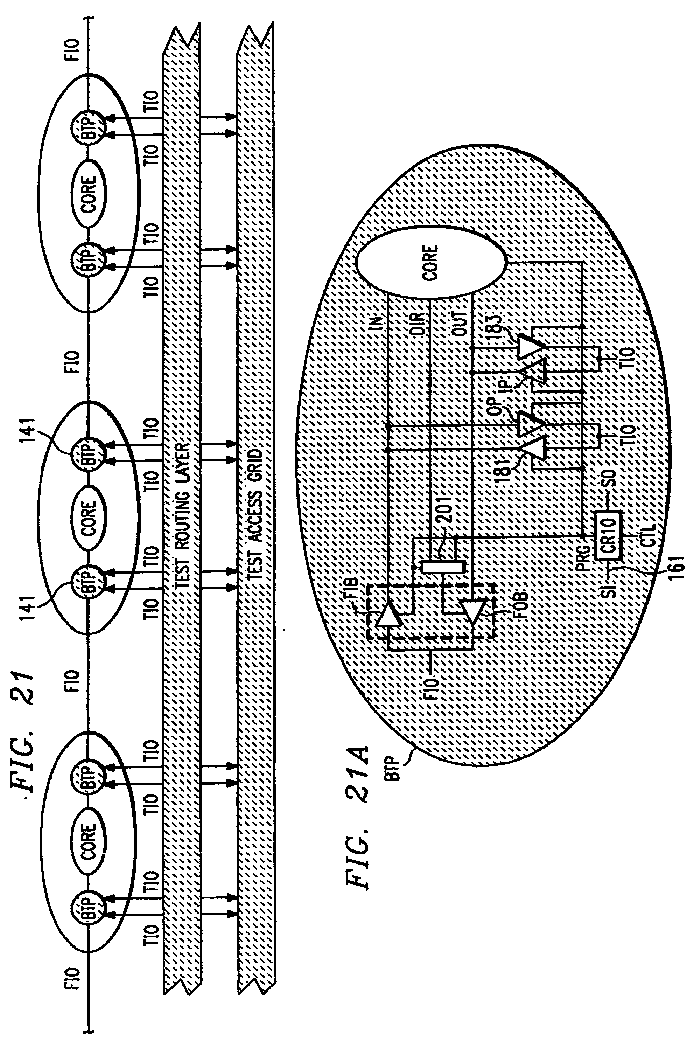

Figures 21 and 21A show another style of BTP. The control circuit CR10 has the same structure as CR9, but with decode outputs as follows. The decode outputs (PRG) from CR10 provide modes, analogous to those described above relative to Figure 20A, but CR10 has sole control of buffers 181 and 183 in Figure 21A instead of sharing that control with DIR via multiplexers (203 and 205) as in Figure 20A. Thus, in the Figure 21A core test mode, CR10 controls buffers 181 and 183. Also one CR10 can control all bussed I/Os of the same core. The separate TIOs for input and output in the BTPs of Figure 21 eliminate the possibility of contention between outputs from the test access grid and core. The two TIOs should preferably be connected to separate grid lines to permit core tests wherein both TIOs are active at the same time.

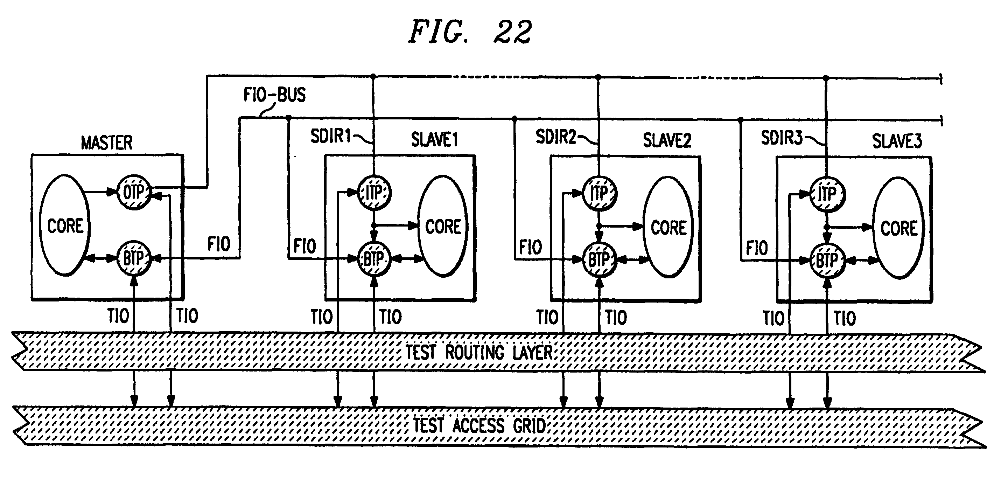

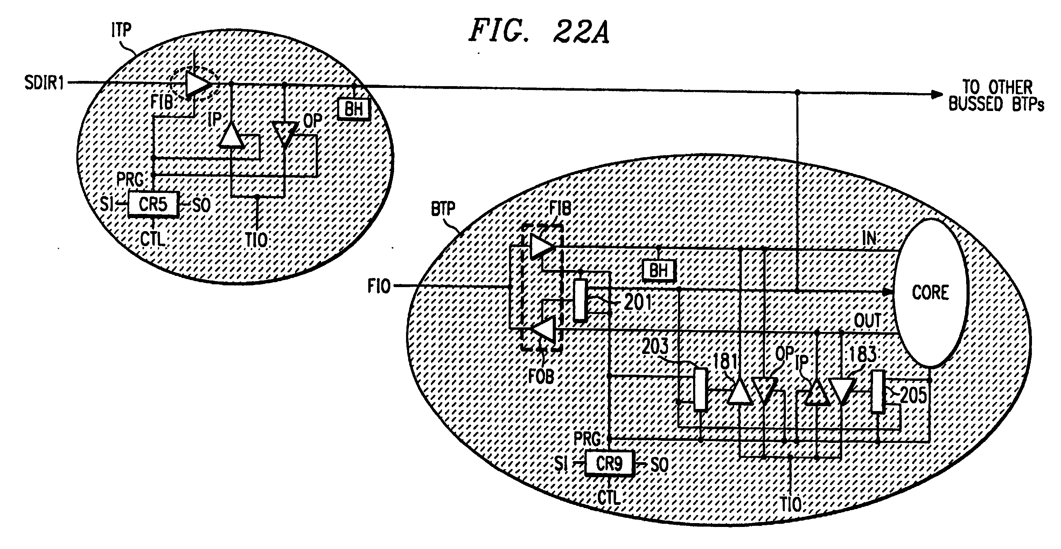

Figures 22 and 22A show an arrangement where one core is a master that communicates to other slave cores slavel-slave3. In this example, the I/O direction of the bus is determined by the master. Each slave has an external input (SDIR1-SDIR3) connected to the master to control its I/O bus to input or output mode. ITPs of Figure 16A are connected to receive the respective inputs SDIR1-SDIR3 and three OTP's (one shown) from Figure 16B are connected to output I/O control from the master to the respective inputs SDIR1-SDIR3. BTPs from Figure 20A are placed on all I/O of the slaves and master. In each slave, ITP is connected to the core and to multiplexers 201, 203 and 205 of each BTP (see Figure 22A) to provide thereto the I/O direction signal (SDIR1 in Figure 22A). Using the path test mode of the ITP and OTP, the I/O direction control interconnect between the master and each slave can be tested. Using the output path test and input path test modes of the BTPs, the I/O interconnects between master and slaves can be tested. Using the core test mode of the ITP and BTPs, each slave core can be tested. Likewise, using the core test mode of the OTP and BTPs, the master can be tested. With the ITPs and BTPs of the slave circuits in normal mode, and with the OTPs of the master circuit in output path test mode, SDIR1-SDIR3 can be driven from the TIOs of the master's OTPs. Then, by selectively placing the master's BTPs in input path test mode or output path test mode, the TIOs of the master's BTPs can be used to input data to or receive data from the slave circuits. In this manner, the operation of the master circuit can be emulated from the test access grid.

Figure 23 illustrates conceptually the programmability of the pad switches 41 by CR1 of Figures 4A-4B to either output a direction control signal or receive a direction control signal to permit testing cores with bi-directional busses. In Figure 23, the pad switch at pad 109 is programmed to output a direction control signal and the pad switches at pads 110 through 125 are programmed to receive the direction control signal. In the programmed configuration, the C2 terminal of the pad switch at pad 109 is connected to drive the DIR1 line, and the DIR1 line is connected to the DIR inputs of the pad switches at pads 110 through 125. These pad switch programming connections are shown in detail in Figures 4A-4D. The C2 terminal of the pad switch at pad 109 is also coupled (via the test access grid) to the TIO of the SDIR1 input to slave 1 of Figure 22. The bi-directional bus TIOs of slave1 are coupled to the C2 terminals of pad switches 110 through 125. During test, an external tester inputs direction control to pad 109 and inputs data to or outputs data from pads 110 through 125. The external direction control causes the pad switches at pads 110 through 125 and the BTPs of slave 1 to input or output data via pads 110 through 125.

Slave 2 of Figure 22 is also shown in Figure 23. The configuration of the pad switches is analogous to that described above, except that the pad switch programming at pads 209 and 210 through 225 uses the DIR2 line of the test access grid. Having more than one direction control signal line in the test access grid allows more than one functional circuit with bi-directional busses to be tested at the same time.

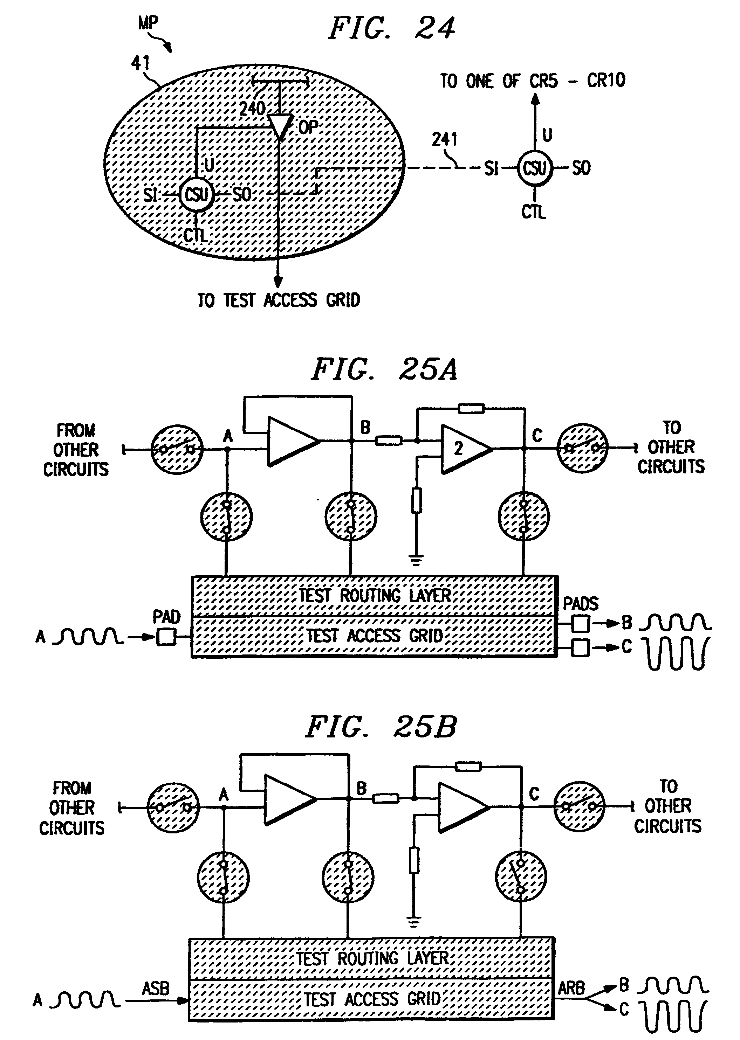

Figure 24 shows a dedicated monitor probe MP comprising a CSU and an OP. MP is controlled by the CSU to either disable OP from outputting signals to the grid line it is wired to or to enable OP to output signal activity from functional path 240 to the grid line.

Figure 24 also shows how ITPs, OTPs, ETPs, and BTPs can be modified to achieve the on-line monitoring function. The update output U of a CSU is connected to the decode input of one of CR5-CR10 to enable monitoring while the circuit (CR5-CR10) is otherwise programmed in the normal mode. When the U output of the CSU is active, and when the test point is programmed for normal mode by scan path 161 (see Figure 16-21), the decode output in CR5-CR10 causes OP to be enabled in ITP and OTP, and causes either OP or buffer 183 to be enabled in ETP or BTP, whereby on-line monitoring is enabled. In Figure 24, the CSU of MP and the CSUs connected to CR5-CR10 are provided on a scan path 241 which is separate from scan path 161.

Figure 25A conceptually illustrates an analog circuit in pad access test mode. In this test mode, an input test point (see Figure 16) isolates the circuit input A from other circuits and connects it to the test access grid. An output test point (see Figure 16) isolates the circuit output C from other circuits and connects it to the test access grid. A monitor probe (see Figure 24) is used to connect an internal circuit node B to the test access grid. The test occurs by inputting analog stimulus to a pad which is connected to the circuit input A through the test access grid, and outputting analog response from the monitored internal node B and circuit output C to two pads via the test access grid. One advantage of pad access testing is that multiple analog inputs can be stimulated while multiple analog outputs are being monitored during the test.

Figure 25B conceptually illustrates the analog circuit in ASB and ARB test access mode. In this test mode, an input test point isolates the circuit input A from other circuits and connects it to the ASB of the test access grid via an ASC (Figures 6-6C). An output test point isolates the circuit output C from other circuits. The test occurs by inputting analog stimulus to ASB (via AT1) which is connected to the circuit input A through the test access grid, and outputting analog response from either the monitored internal node B (connection conceptually shown in Figure 25B) or circuit output C (connection not shown) to ARB via an ASC (Figures 6-6C), and ultimately to AT2.

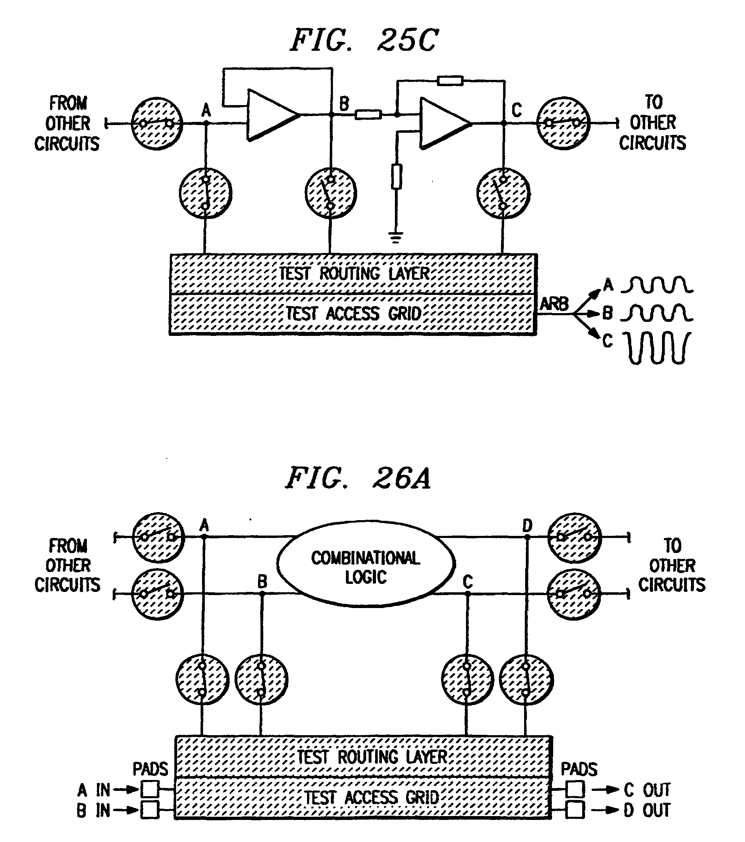

Figure 25C conceptually illustrates the analog circuit being monitored while it is in normal functional operation. In this example both the input and output test points are capable of monitoring as described relative to Figure 24. The input test point is shown enabled in Figure 25C to allow the input A to be output on ARB to AT2. Also, the monitor probe could be enabled to allow the internal node B to be output on ARB to AT2, or the output test point could be enabled to allow the output C to be output on ARB to AT2.

Figure 26A illustrates conceptually pad access testing of combinational digital logic. The test inputs (A & B) are applied to pads and routed through the test access grid and input test points to be input to the circuit. The test outputs (C & D) from the circuit are routed through output test points and the test access grid to pads.

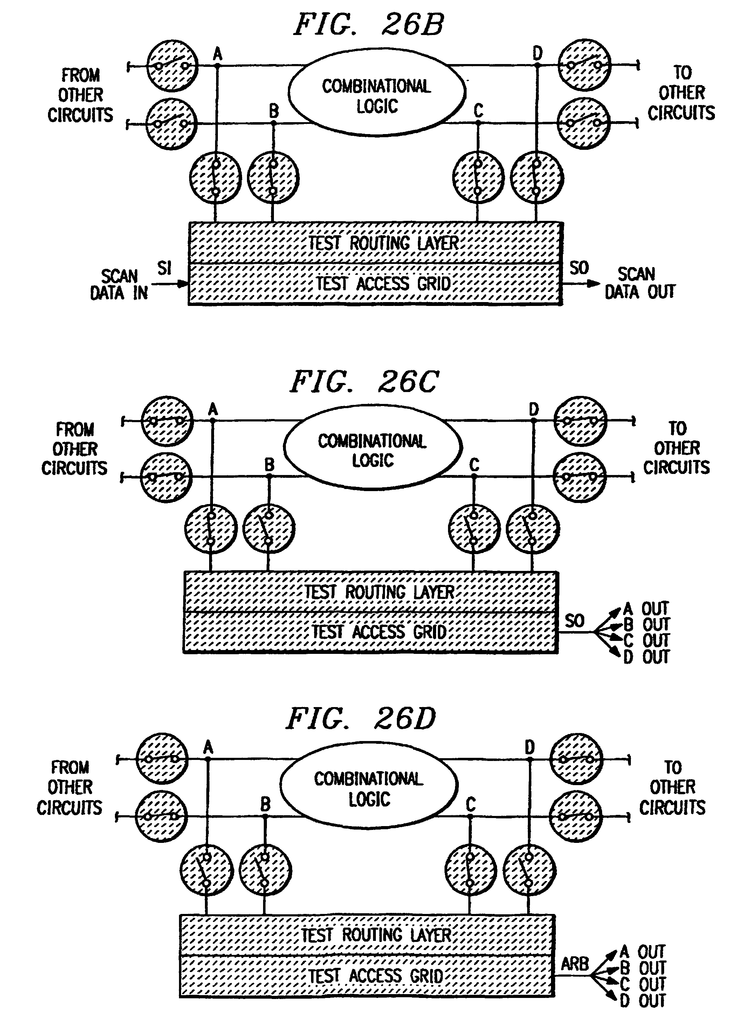

Figure 26B illustrates conceptually scan access testing of the combinational logic. The test inputs are scanned in and output from DSCs in the test access grid and routed through the input test points to the input of the circuit. The test outputs are routed through output test points to DSCs in the test access grid to be captured and scanned out for inspection.

Figure 26C illustrates conceptually on-line monitoring of the combinational logic using the test access grid scan path 50. Input A is routed to the scan path 50 (see Figure 5), via an input test point and a DSC, to be observed on TDO. Likewise the other input and two outputs are similarly routed (not shown) to be output on TDO.

Figure 26D illustrates conceptually on-line monitoring of the inputs and outputs of the combinational logic using test points, ASCs and ARB to output on AT2. The connection for monitoring output C is shown.

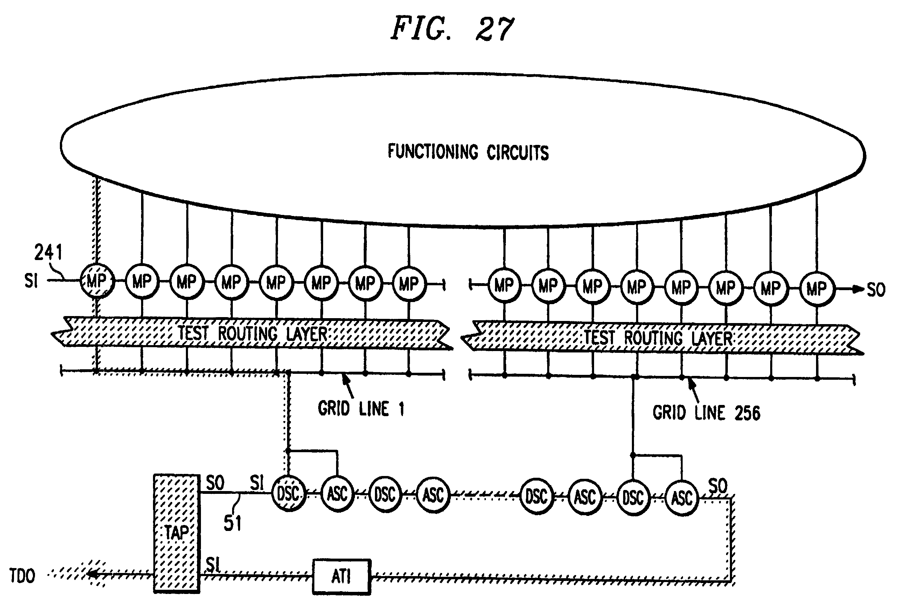

Figure 27 illustrates the selection of a functional digital signal to be monitored and the shaded routing of that signal to a DSC programmed to receive the signal and pass it down the scan path 51 through bypassed DSCs, ASCs, and ATI (Figures 5 - 6C) to be output via the TAP on TDO.

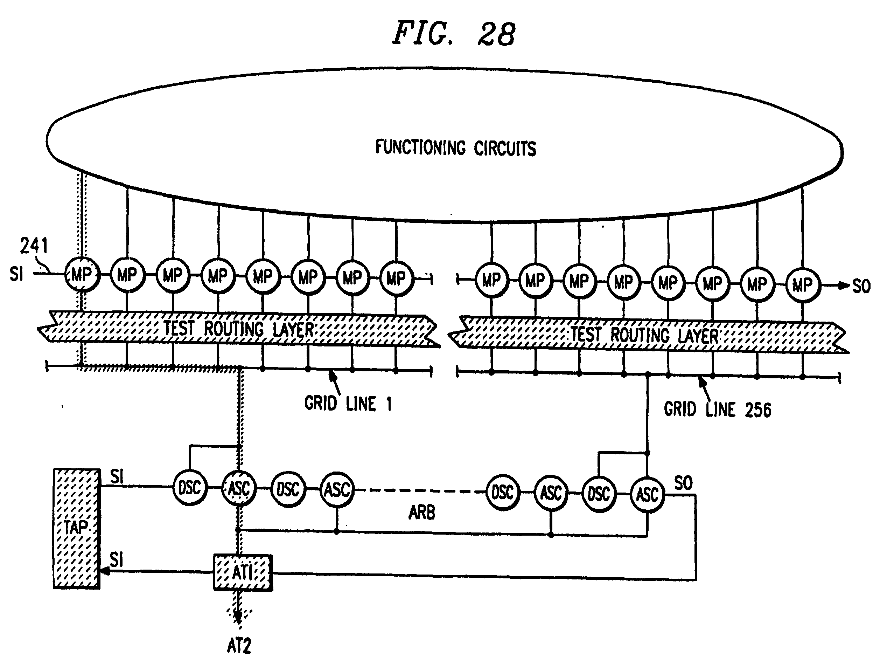

Figure 28 illustrates the selection of a functional digital or analog signal to be monitored and the shaded routing of that signal through an ASC to be output via ATI on AT2 (Figures 6-6C). Note that the above-described structure and operation of ATI permit the monitoring of Figure 27 to occur simultaneously with the monitoring of Figure 28. In particular, the AT2 buffer of Figure 6C should be enabled via scan path 51 of Figure 6B, and then the scan path 51 of Figure 6B can be bypassed, thus permitting both analog and digital signals to traverse ATI.

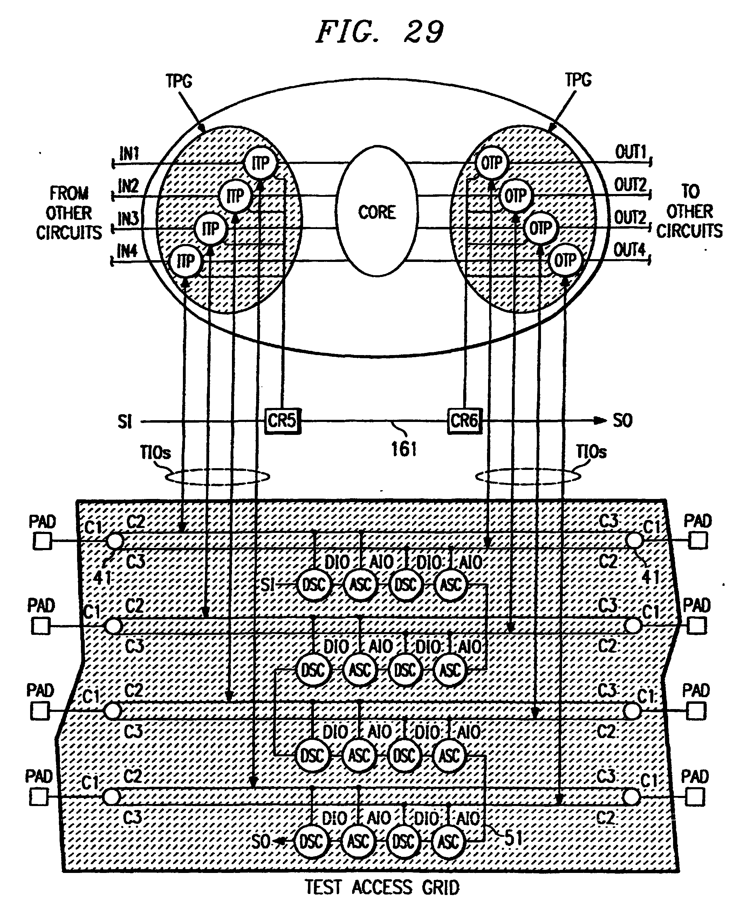

Figure 29 illustrates input and output test point groups (TPGs), each controlled by a single control circuit CR5/CR6. Each TIO traverses the test routing layer (not shown) and is connected to a pair of pad switches 41 and to scan path 51 via a grid line of the test access grid.

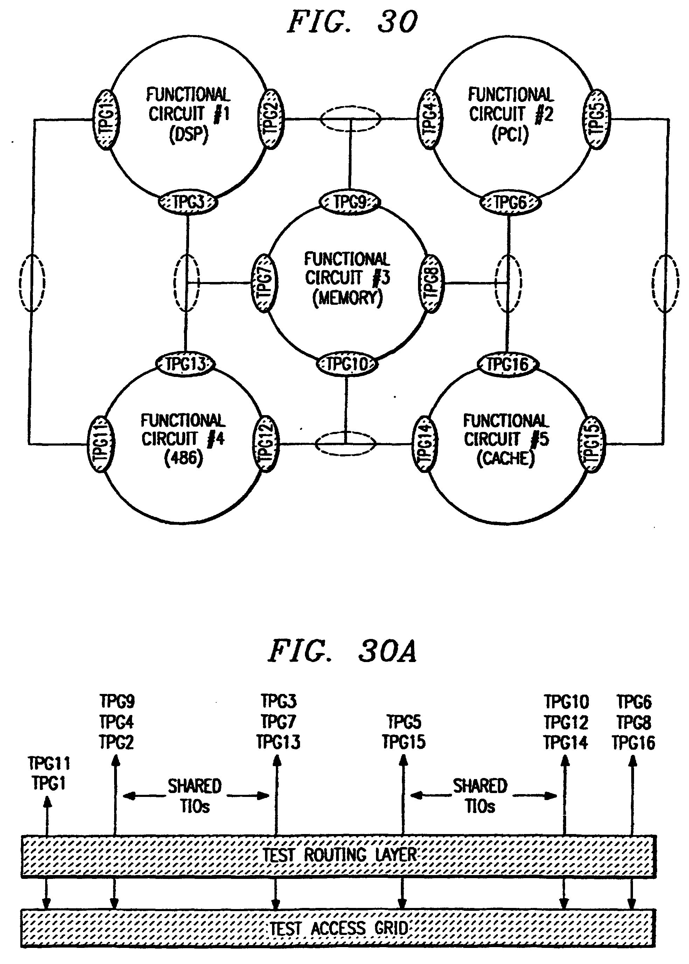

Figure 30 illustrates an IC comprising multiple complex core functions. The boundary of each core is equipped with test point groups (TPG). The dashed circles indicate where plural core boundaries are connected and TIOs may be shared among the associated TPGs, reducing the number of TIOs to be routed in the test routing layer. The resulting shared TIOs are shown in example Figure 30A.

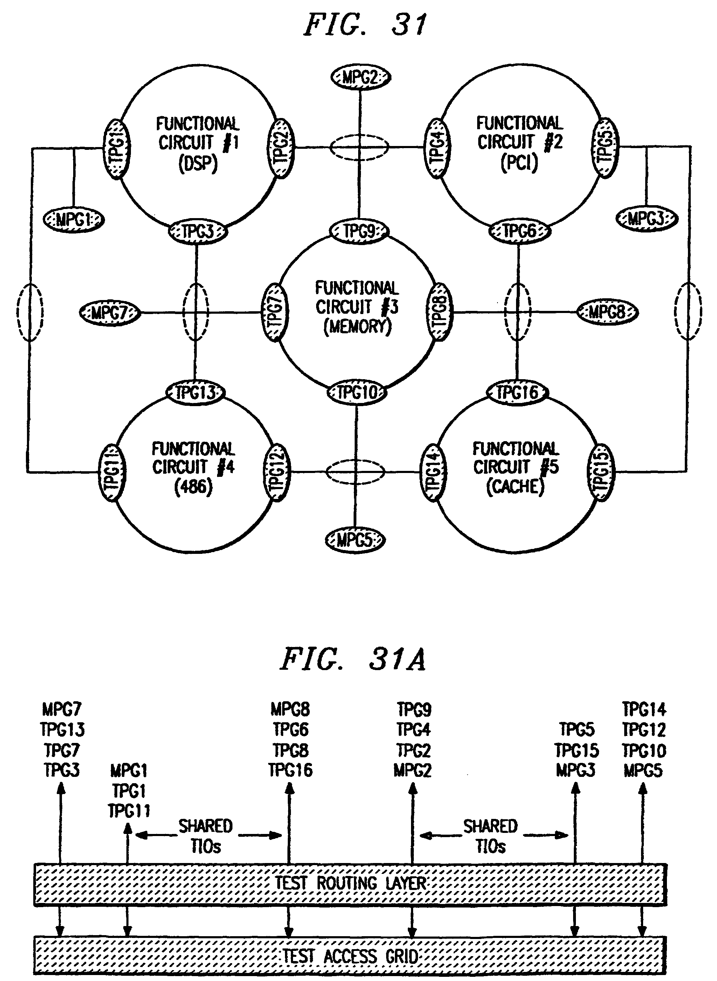

Figure 31 is similar to Figure 30 except that monitor probe groups (MPG) are also included and routed to the test access grid. Again the dashed circles indicate common boundary connections that can be exploited to reduce the amount of TIO routing between MPGs/TPGs and the test access grid. The resulting shared TIOs are shown in exemplary Figure 31A. Note that the MPGs of Figure 31 permit the core boundary connections to be monitored even while being driven from the TPGs.

Note that, although sharing TIOs among TPGs of connected core boundaries reduces TIO routing, it also prevents testing the path connections between the core boundaries.

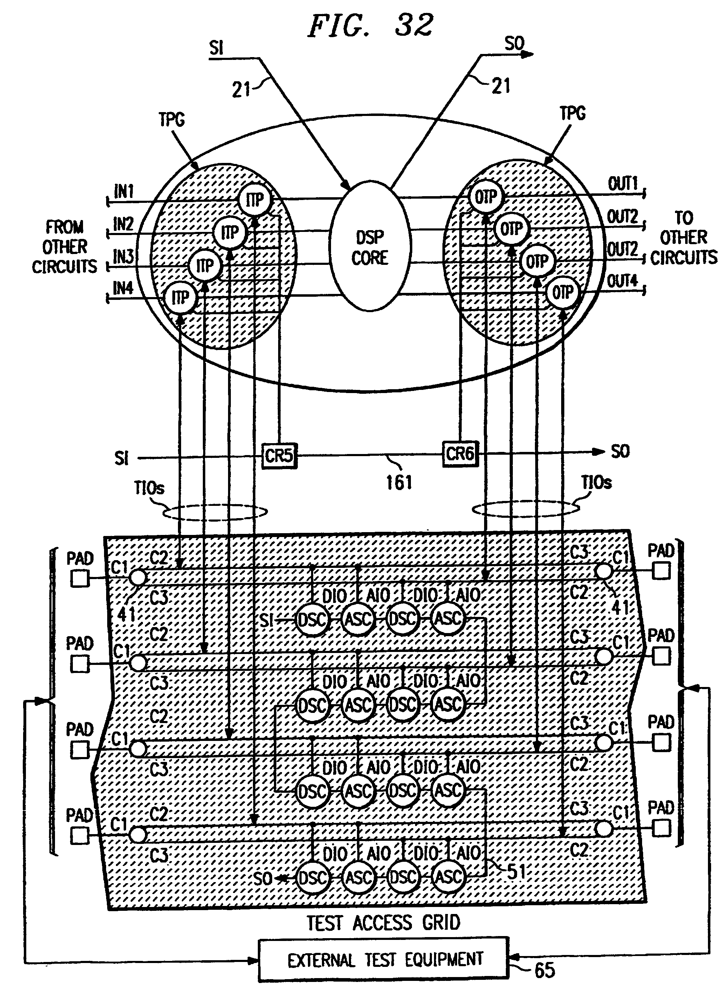

Figure 32 is similar to Figure 29 and illustrates that emulation of embedded scannable cores, such as DSP cores, can be easily accomplished using the test architecture provided by the invention. Today during emulation of an individually packaged DSP, the device is scanned to input/output internal states and setup execution of a software algorithm. After being scanned, the device executes for a predetermined time and halts. These scan, execute, and halt steps are repeated while the I/O pins of the device are controlled and monitored by external test equipment to verify device operation. One problem with embedded DSP core emulation is that the I/O is not easily observed since the DSP may be only one of many cores in a large IC. Using the pad access provided by the test access grid and TPGs, in combination with a conventional internal scan path 21 in the DSP core (see also Figure 2) and a conventional external tester 65, DSP emulation can be performed even though the DSP is embedded inside an IC.

The basic framework of the test access grid can be extended to include a test controller embedded within the IC to automate the process of testing the IC. Such automatic testing of ICs can benefit many areas, from manufacturing to end user applications. For example, wafer testing and burn-in would be simplified if each die could be instructed to test itself. After packaging, an IC could be instructed again to test itself. Further, after mounting the IC on a board the end user could again instruct the IC to test itself.

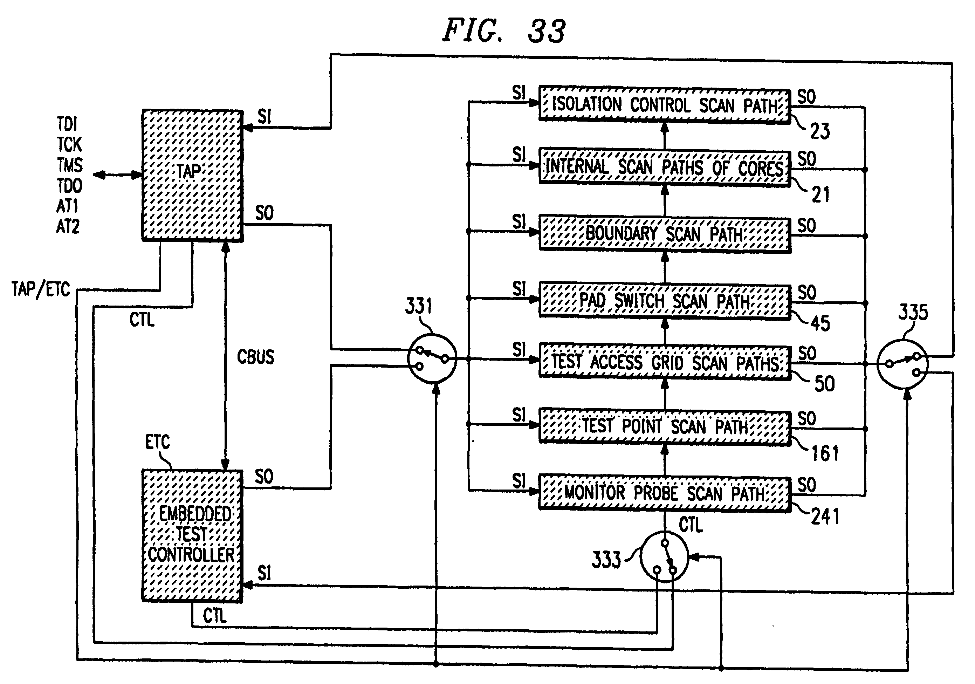

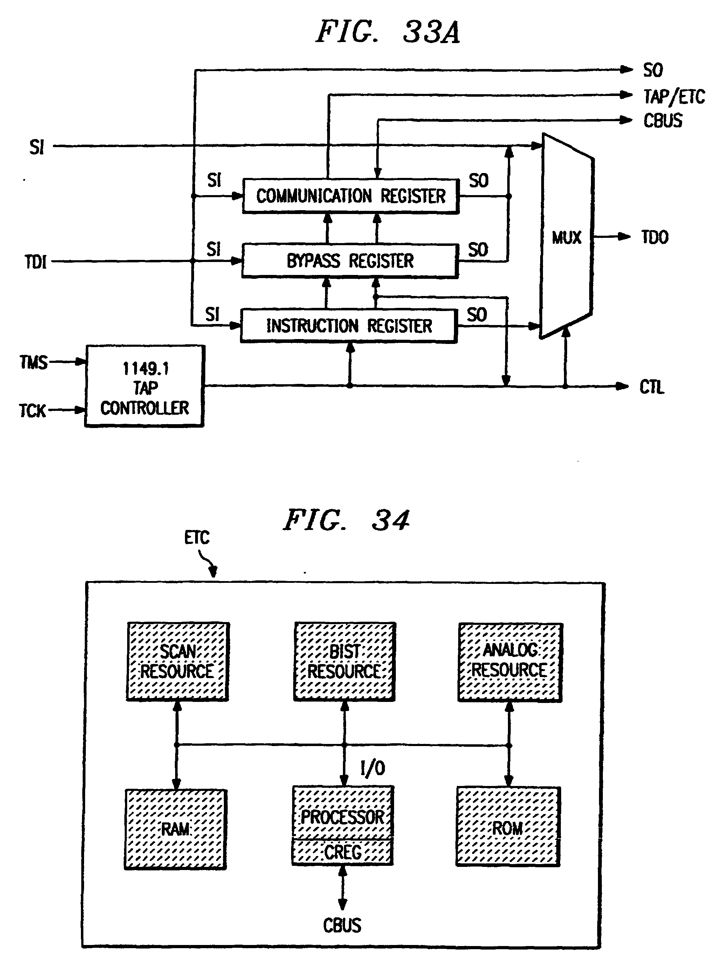

Figure 33 illustrates an embedded test controller (ETC) connected to the TAP by a communication bus (CBUS) and coupled to all scan paths by switches 331, 333 and 335. Commands, data, and status are communicated between the TAP and ETC via the CBUS. Normally the TAP will be connected via the switches to all scan paths for control of scan operations therein. However, the TAP can receive external control input instructing the TAP to connect the ETC to the scan paths via the switches, command ETC to execute tests, and monitor the test execution via status reads. Once the ETC has been connected to the scan paths and commanded to test, it operates in stand-alone fashion, independent from the TAP. However, the TAP can command the ETC to halt and take back control of the scan paths at any time if it receives external input to do so.

Figure 33A illustrates a TAP design for cooperation with ETC. A communication register is scannable from TDI to update commands and data to ETC via CBUS, capture status information from ETC via CBUS, and update the TAP/ETC signal to select either the TAP or ETC to control the Figure 33 scan paths via switches 331, 333 and 335. The communication register and all scan registers of Figure 33 can be, for example, conventional IEEE STD 1149.1 Test Data Registers as described in IEEE STD 1149.1. The CTL output in Figure 33A is preferably conventional 1149.1 scan control, including a test data register selection signal from the 1149.1 instruction register, and capture, shift and update control signals from the 1149.1 TAP controller. The CTL output controls selection and operation of all scan paths in Figure 33 when the TAP is selected by TAP/ETC. The aforementioned signals in the CTL output also control selection and operation of the communication register and the 1149.1 bypass register. The instruction register is controlled from the TAP controller according to conventional 1149.1 operation.

Figure 34 illustrates an exemplary architecture of the ETC. The ETC has a data processor circuit for controlling tests, a communication register (CREG) connected to CBUS for communicating with the TAP, RAM for temporary test program/data store, ROM for permanent test program/data store, a scan resource for accessing scan paths, a built-in-self-test (BIST) resource for automatic testing of digital circuits, and an analog resource for testing digital or analog circuits. The processor communicates to the RAM, ROM, and other illustrated resources through an I/O bus.

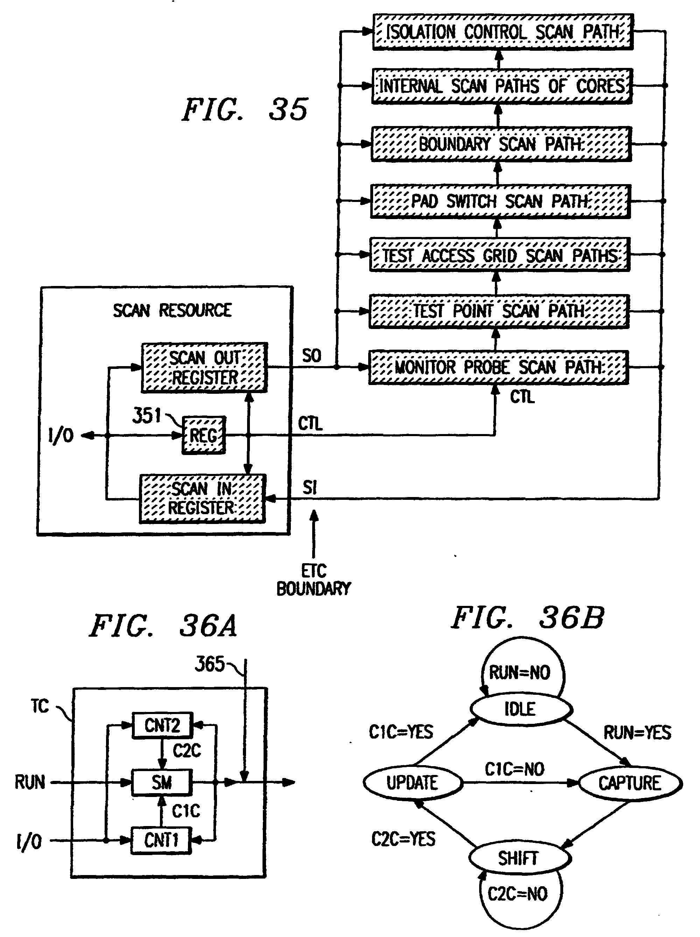

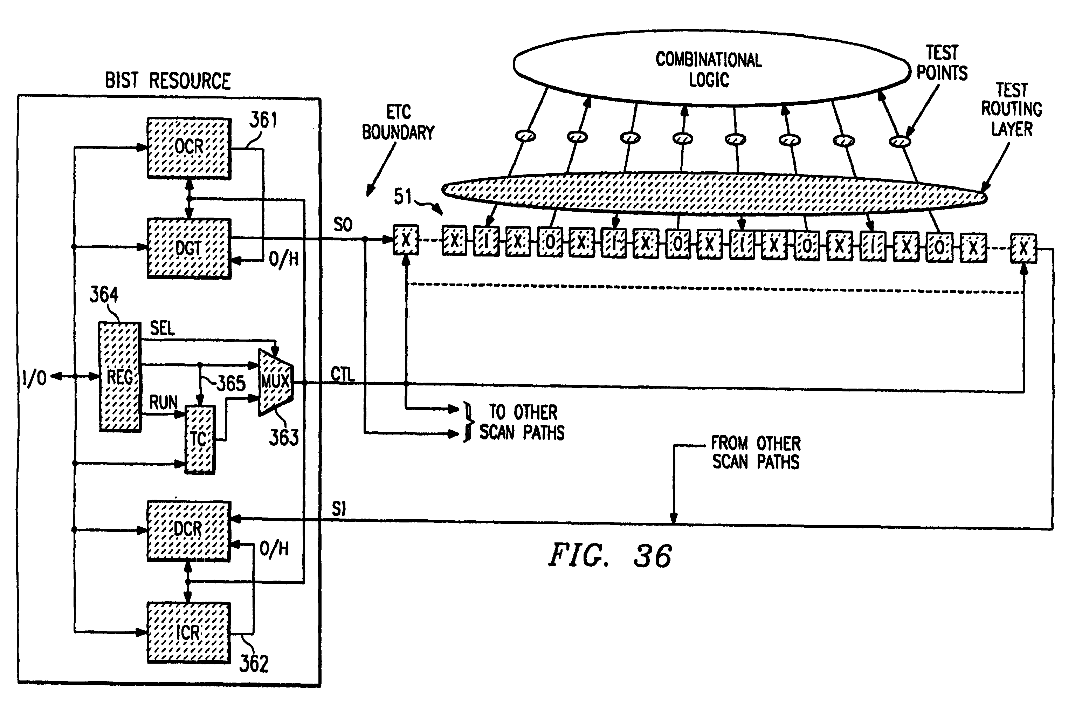

Figure 35 illustrates the ETC's scan resource which includes a scan control register 351, a scan output register, and a scan input register. The ETC uses the scan resource to access the scan paths. At the beginning of a test program, the processor (Figure 34) may need to setup the scan paths before starting the test. For example, a first test setup procedure may involve scanning the test access grid data scan path 51 to load initial values in the DSCs, ASCs, and ATI. A second test setup procedure may involve scanning the test access grid control scan path 52 to collapse the bit length of path 51 (see Figures 5,6,7) to optimize path 51 for more rapid scan testing of a particular circuit. A third test setup procedure may involve scanning the test point scan path 161 to connect the circuit to be tested to the test access grid scan path. After these setup procedures, scan testing can be performed on the circuit. The ETC's processor circuit can readily provide in register 351 capture-shift-update control and path select control that mimics the relevant conventional TAP scan path control. Figure 35 (and Figure 36) shows ETC already connected to the scan paths via the Figure 33 switches (not shown). The scan in and scan out registers are parallel accessible by the processor circuit via the I/O bus, thus permitting the ETC processor to have data communication with any selected core circuit of the IC.

Figure 36 illustrates the ETC's BIST resource which includes a controller, a serial data generator/transmitter (DGT), a serial data compactor/receiver (DCR), a serial input control register (ICR), and a serial output control register (OCR). The ETC uses the BIST resource to automatically generate/transmit test data to and compact/receive test data from a circuit coupled to the test access grid data scan path 51 by test points and the test routing layer. Even though the length of path 51 can be reduced (see Figures 5,6,7), there will sometimes be more scan bit positions in the path 51 than inputs to plus outputs from the circuit under test, because only a limited number of consecutive unused bits can be bypassed in path 51 without causing registering problems. In a string of consecutive unused bits, one or more of those bits may be retained in the path to ensure proper registering of data. These retained scan bit positions are indicated by X's in the scan path 51 shown connected to the BIST resource and to the combinational logic under test. The scan bit positions that provide output to and input from the combinational logic during test are indicated by O and I, respectively.

The DGT has two modes of operation, generate and transmit. For the generate mode, the DGT includes a conventional linear feedback shift register that produces a pseudorandom pattern sequence and shifts that sequence out to the scan path. For the transmit mode, the DGT includes a register to input parallel data from the I/O bus and serially output the data to the scan path. In transmit mode, the ETC's data processor writes data to the DGT via the I/O bus.

The DCR has two modes of operation, compaction and receive. For the compaction mode, the DCR includes a conventional single input signature analyzer that receives serial data from the scan path and compacts it into a signature. For the receive mode, the DCR includes a register to receive serial data from the scan path and output the data in parallel to the I/O bus. The ETC's data processor reads data from the DCR via the I/O bus.

The data generation mode of the DGT and data compaction mode of the DCR are well known conventional BIST operations. Likewise, the data transmit mode of the DGT and data receive mode of the DCR are well known conventional scan test operations.

During test, a typical BIST controller controls a scan path to receive data from the DGT and update the data to a circuit under test, then controls the scan path to capture data from the circuit under test and output the data to the DCR. In a typical BIST application, the bit length of the scan path connected between DGT and DCR will equal the sum of inputs and outputs of the circuit under test, one bit per input and one bit per output, and with no interleaving of the input and output bits. However, for the reasons given above, the number of scan bits in Figure 36 will rarely equal the sum of inputs and outputs of a circuit under test. Moreover, the O and I bits can normally be expected to be interleaved in the scan path as shown in Figure 36, because the scan path is re-usable for testing many circuits and thus is not custom-designed for testing any particular circuit. To accommodate interleaved I and O bits and mismatches between the number of scan path bits and the sum of inputs and outputs of the circuits under test, the following two basic rules apply:
Rule 1 - Only scan path output bit positions (O) can update data from the DGT
Rule 2 - Only the data captured in scan path input bit positions (I) can be input to the DCR.

To implement these rules, the BIST resource includes the additional OCR and ICR circuits mentioned previously. Before a BIST operation, the processor will parallel load control data into the OCR and ICR via the I/O bus. The control data loaded into the OCR will program the DGT to shift test stimulus data only into the O (output) bit positions of the scan path. The control data loaded into the ICR will program the DCR to input only data captured in I (input) bit positions of the scan path. The control data loaded into the OCR maps the location of the scan path O bit positions of a selected circuit under test. The control data loaded into the ICR maps the location of scan path I bit positions of a selected circuit under test. Unless the OCR and ICR are large enough to store all the I and O bit mapping data for a scan operation through the test access grid scan path, the processor will have to communicate with the OCR and ICR during test to provide additional bit mapping data.

Prior to starting a test, the DGT will be set to operate as a generator or a transmitter, and the DCR will be set to operate as a compactor or receiver. When the BIST resource starts a test, a 2-to-1 multiplexer 363 outputs scan control to the scan path, OCR, DGT, DCR, and ICR. One input of multiplexer 363 is connected to a register 364 so the data processor circuit of ETC can provide scan control as described above relative to Figure 35. The other input of multiplexer 363 is driven by the output of a test controller circuit TC which can provide the required capture-shift-update control at higher speeds than can the data processor circuit. The processor loads a select signal Sel into register 364 via the I/O bus to control the multiplexer 363.

Figure 36A shows one example of TC, including a state machine circuit SM and counter circuits CNT1 and CNT2. The counters are loaded with count information from the I/O bus, CNT2 receiving information corresponding to the bit length of the scan path, and CNT1 receiving information corresponding to the number of test patterns to be shifted in/out of the path. CNT2 counts with each bit shift and outputs signal C2C when done, and CNT1 counts with each update and outputs signal C1C when done. When the data processor loads register 364 with a Run signal, state machine SM begins to operate according to the state diagram shown in Figure 36B, namely outputting conventional capture-shift-update control until signal C1C indicates that all patterns have been applied. Signal C2C indicates when a given shift sequence is complete. Path select information is provided to TC from register 364 at 365, so the TC output mimics the relevant conventional TAP scan control.

Initially in Figure 36, the scan path 51 must be scanned to load a first data pattern into the X, I, and O bit locations. During this first scan operation, the bit mapping data is shifted out from OCR at 361 in synchronism with the scanning in path 51. When one of the X bits or I bits is being input to the scan path, DGT is placed in a hold mode by the OCR output 361 connected to the DGT's operate/hold input (O/H). When DGT data (one of the O bits) is being input to the scan path, DGT is placed in operate mode by the OCR output 361 connected to the DGT's O/H input. At the end of the first scan operation, the O bit positions contain stimulus data from DGT, and the X and I bit positions contain dummy data. If the DGT operates as a data generator, the O bit positions will be filled with data generated by the DGT. If the DGT operates as a data transmitter, the O bit positions will be filled with data from the ETC's ROM or RAM. After loading the scan path, the stimulus data is updated to the combinational logic and then the response data is captured from the combinational logic.

Following the capture operation, ICR is enabled to output bit mapping data to the DCR. As captured data is being shifted into the DCR, the bit mapping data shifted out at 362 from the ICR to the DCR's operate/hold (O/H) input determines whether the data is input to the DCR or ignored by the DCR. The bit mapping data will only allow the DCR to input I bit positions from the scan path. If the DCR operates as a data compactor, the signature it produces will be a signature of only I bit positions from the scan path. Similarly, if the DCR operates as a data receiver, the data it receives will only be from the I bit positions of the scan path. While the scan path is outputting test response data to the DCR, the DGT is inputting the next test input pattern to the scan path. This bit mapped scan input/output process continues until the test of the combinational logic is complete.

The SI, SO and CTL lines of the BIST resource of Figure 36 and the scan resource of Figure 35 are multiplexed to the ETC boundary under control of the ETC data processor. The ETC data processor can be realized by, for example, a conventional 8-bit microprocessor core design.

The BIST resource operation of Figure 36 can also be carried out by an external tester using the TAP to access scan path 51 (see 65 in Figure 6).

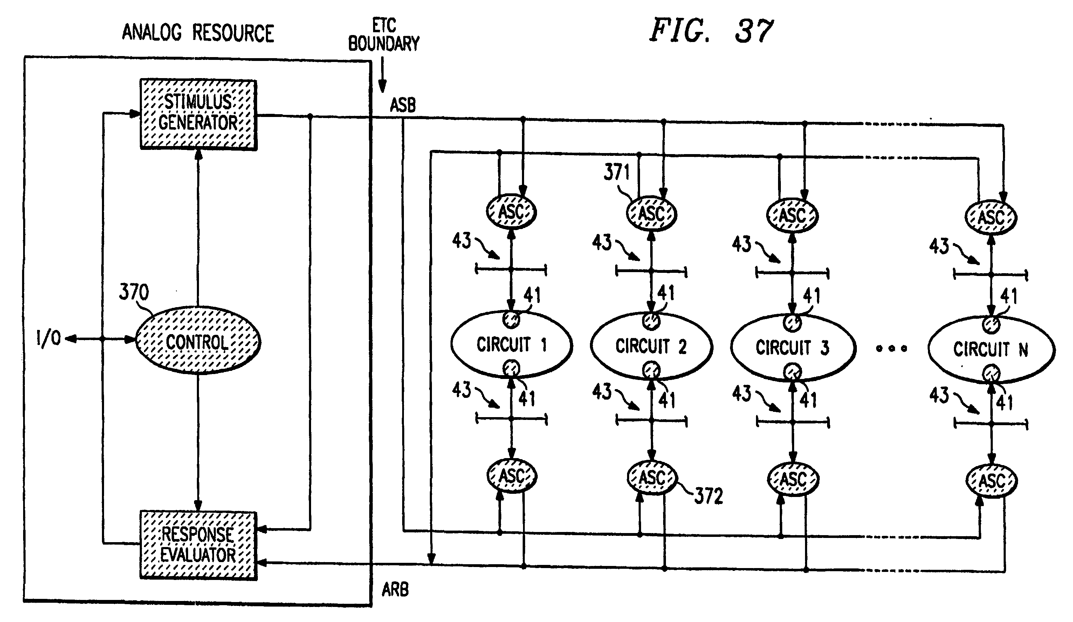

Figure 37 illustrates the ETC's Analog resource which includes a controller, a stimulus generator, and a response evaluator. The analog resource can be switchably connectable to the ASB and ARB lines (see Figure 6) at the ETC boundary. The ASC's are connectable to circuits 1- N via grid lines at 43, routing layer, and test points 41. The ETC processor communicates with the analog resource via the I/O bus to set up and execute analog tests on a selected circuit.

The controller at 370 regulates the stimulus generator and response evaluator to execute a test on a circuit selected by the ETC processor. The analog resource provides three types of tests; delay test, gain/loss test, and phase test. When a circuit has been selected for testing, the ETC scan resource can be used to connect the circuit's input to the stimulus generator output via the ASB, ASC, grid line, routing layer, and test point. The output from the selected circuit will be connected to the response evaluator input via the ARB, ASC, grid line, routing layer, and test point, using the ETC scan resource. All tests operate by comparing a stimulus output from the stimulus generator against a response input to the response evaluator. Before testing a circuit, the analog resource is setup to calibrate the input and output of the circuit to be tested.

Input calibration occurs via the following steps;
(1) The ASC 371 connected to the input of the circuit to be tested is setup to input a signal from ASB and output the signal on ARB (see Figure 6A).
(2) The stimulus generator outputs on ASB a square wave signal which is received at ASC and at the response evaluator.
(3) The response evaluator measures and stores the delay difference between the square wave received from the stimulus generator and the square wave fed back from the ASC via the ARB.
(4) The stimulus generator outputs a sine wave of set amplitude to the ASC and to the response evaluator.
(5) The response evaluator measures and stores the amplitude difference between the sine wave received from the stimulus generator and the sine wave fed back from the ASC.
(6) The stimulus generator outputs a sine wave of set frequency to the ASC and to the response evaluator.
(7) The response evaluator measures and stores the phase difference between the sine wave received from the stimulus generator and the sine wave fed back from the ASC.

Output calibration occurs via the same 7 steps described above, but using the ASC 372 connected to the output of the circuit to be tested. The input and output calibration procedures provide data indicating what affect the grid line, routing layer and test point loads of the ASCs have on the delay, gain/loss, and phase tests to be performed on the circuit. When the actual circuit tests are performed, the data obtained from the calibration procedures can be used to adjust the results of the actual circuit test to get a more accurate measurement of the circuit performance regarding delay, gain/loss, and phase measurements. For example, if calibration data showed a 100 ps input load delay and a 200 ps output load delay, and the circuit delay test showed a 1 ns delay from input to output, the actual input to output delay through the circuit would be closer to 700 ps (1 ns - 300 ps).

Delay testing occurs by the following steps;
(1) The input ASC 371 and associated test point 41 are set to connect ASB to the circuit input, and the output ASC 372 and associated test point 41 are set to connect ARB to the circuit output.
(2) The stimulus generator outputs a square wave signal to the circuit input and to the response evaluator.
(3) The response evaluator measures and stores the delay difference between the square wave received from the stimulus generator and the square wave received from the circuit output.

Gain/Loss testing occurs by the following steps;
(1) The input ASC 371 and associated test point 41 are set to connect ASB to the circuit input, and the output ASC 372 and associated test point 41 are set to connect ARB to the circuit output.
(2) The stimulus generator outputs a sine wave of fixed amplitude to the circuit input and to the response evaluator.
(3) The response evaluator measures and stores the amplitude difference between the sine wave received from the stimulus generator and the sine wave received from the circuit output.

Phase testing occurs by the following steps;
(1) The input ASC 371 and associated test point 41 are set to connect ASB to the circuit input, and the output ASC 372 and associated test point 41 are set to connect ARB to the circuit output.
(2) The stimulus generator outputs a sine wave frequency to the circuit input and to the response evaluator.
(3) The response evaluator measures and stores the phase difference between the sine wave received from the stimulus generator and the sine wave received from the circuit output.

It should be understood that the calibration, delay test, gain/loss test, and phase test performed by the internal analog resource of the ETC can also be performed by an external tester connected to AT1 and AT2 of ATI of Figure 6. It should also be clear that all above-described operations of ETC can also be accomplished using external tester 65 connected to the TAP and ATI.

Because IC power is needed to perform the test and emulation operations described above, the IC's power supply pads cannot be used to access the test access grid of Figure 4. Thus, the IC power supply pads are not equipped with pad switches and do not access any of the grid lines of Figure 6. Because the TAP and ATI are used to perform test/emulation operations, the TAP and ATI pads are not equipped with pad switches and do not access any of the grid lines of Figure 6. Accordingly, in order to maximize the number of grid lines that can be accessed from the IC's pads, power supply pads and TAP and ATI pads should preferably be positioned opposite one another with respect to the geometry of the test access grid, in order to maximize the number of pairs of oppositely positioned pads to which grid lines can be coupled.

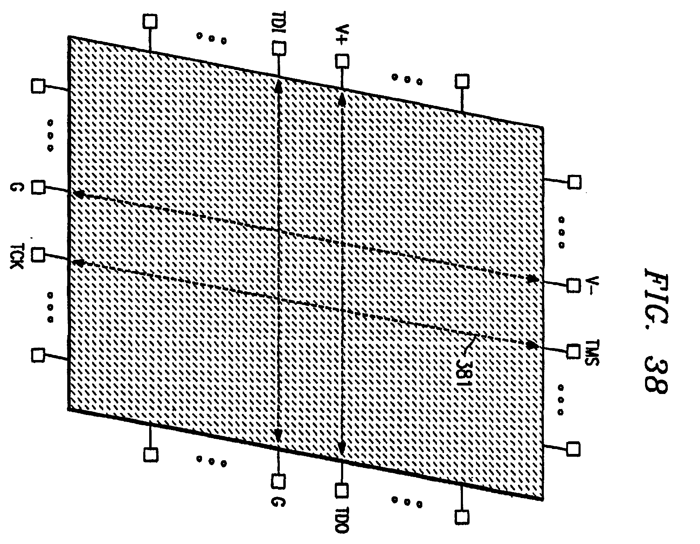

Figure 38 shows an example of such a pad arrangement, wherein each power supply pad or TAP pad is positioned oppositely across the die from either a power supply pad or a TAP pad. To the extent possible then, the TAP, ATI and power supply pads can be paired together and located on opposite sides of the IC die in mutually opposed relationship, for example the illustrated relationship between the TMS and TCK pads, wherein a line 381 defined by the TMS and TCK pads extends in substantially parallel relationship relative to the grid lines associated with pads 1 and 192 of Figure 4. This arrangement of TAP, ATI and power supply pads will advantageously maximize the number of grid line pairs accessible from the IC's pads. Put another way, if TMS and TCK are assigned to mutually opposed pads 1 and 192 of Figure 4, respectively, then only one grid line pair is sacrificed, whereas two grid line pairs are sacrificed if TMS is assigned to pad 1 and TCK is assigned to pad 160.

Note that a grid line can be positioned to extend between, for example, the TMS and TCK pads of Figure 38, but such grid line would of course be scan accessible only. Note also that any desired number of scan-accessible-only grid lines can be provided wherever desired in the IC. Such scan-accessible-only grid lines are identical to the Figure 6 grid lines, except they are not connected to any pad switches.

All CSU cells disclosed herein should be reset from the TAP in the conventional manner upon power-up of the IC. The reset state of CSU 23 (Figure 2) should cause the isolation elements 25 to connect the pads to the functional circuitry. The decoding in CR5-CR10 (Figures 16-21) will preferably respond to the reset state of the CSU cells to cause the ITP, OTP, ETPs and BTPs to assume their respective normal modes (without monitoring). All other CSU cells, when reset, will cause the associated test circuitry to be disabled.

Although exemplary embodiments of the present invention are described above, this description does not limit the scope of the invention, which can be practiced in a variety of embodiments.

## Claims

1. An integrated circuit, comprising:
functional circuitry for performing normal operating functions of the integrated circuit, including a plurality of nodes distributed across the integrated circuit;
a plurality of conductive signal means (43) extending across the integrated circuit;
each of said conductive signal means having a plurality of signal paths connected thereto at respective locations along a length thereof, each said signal path connectable to a respective one of said nodes; and
each of the conductive signal means (43) having one or more associated pads for providing thereto or receiving therefrom signals respectively collected from or distributed to said signal paths;
**characterised in that** the pads are bond pads, **in that** the bond pads are selectively connectable to the conductive signal means, and
**in that** the conductive signal means (43) are arranged in a grid.

2. The integrated circuit of claim 1, wherein said integrated circuit comprises:
a scan path coupled to the or each conductive signal means (43) for receiving therefrom or providing thereto signals respectively collected from or distributed to said signal paths.

3. The integrated circuit of claim 1 or claim 2,
wherein the or each conductive signal means (43) extends across the integrated circuit in a generally linear direction between an associated pair of bond pads.

4. The integrated circuit of claim 3,
wherein a pair of the conductive signal means extends across the integrated circuit in a generally linear direction between a particular pair of associated bond pads.

5. The integrated circuit of claim 4,
wherein the conductive signal means (43) of each pair is selectively connectable at opposite ends to respective ones of the associated pair of bond pads between which the conductive signal means extend.

6. The integrated circuit of any one of claims 3 to 5,
wherein the conductive signal means comprise two sets, those within each of those sets extending generally in parallel with one another.

7. The integrated circuit of any preceding claim comprising
one or more pairs of further bond pads (V+, V-, TDO, TMS, TDI, TCK) not connectable to the said conductive signal means, the bond pads of the, or each of, these pairs being located opposite each other with respect to the grid and at the ends of a geometric line parallel to one of the said conductive signal means.

8. The integrated circuit of claim 7,
wherein said further bond pads comprise a power supply bond pad.

9. The integrated circuit of claim 7 or claim 8,
wherein said further bond pads comprise a bond pad that is for connection to an external scan test controller.

10. The integrated circuit of any preceding claim,
wherein the conductive signal means (43) comprise a conductive signal collector.

11. The integrated circuit of any preceding claim,
wherein the conductive signal means (43) comprise a conductive signal distributor,

12. The integrated circuit of claim 10 and claim 11, when dependent on claim 2, wherein the plurality of signal paths comprise:
a first group of signal paths connected to said conductive signal collector, each said signal path of said first group connectable to a respective one of a first group of said nodes and wherein said one or more bond pads are coupled to said conductive signal collector to receive therefrom signals collected from said first group of signal paths;
a second group of signal paths connected to said conductive signal distributor, and said scan path coupled to said conductive signal distributor to provide thereto signals to be distributed to said second group of signal paths.

13. The integrated circuit of claim 10 and claim 11, when dependent on claim 2,
wherein said plurality of signal paths comprises:
a first group of signal paths connected to said conductive signal collector, each said signal path of said first group connectable to a respective one of a first group of said nodes and wherein a scan path is coupled to said conductive signal collector to receive therefrom signals collected from said first group of signal paths;
a second group of signal paths connected to said conductive signal distributor, each said signal path of said second group connectable to a respective one of a second group of said nodes and wherein a bond pad is coupled to said conductive signal distributor to provide thereto signals to be distributed to said second group of signal paths.

## Patentansprüche

1. Ein integrierter Schaltkreis, der folgendes umfaßt:
Funktionsschaltungen für die Durchführung normaler Betriebsfunktionen des integrierten Schaltkreises, die eine Mehrzahl von über den integrierten Schaltkreis verteilten Knotenpunkten enthalten;
eine Mehrzahl von leitfähigen Signaleinrichtungen (43), die sich über den integrierten Schaltkreis erstrecken;
wobei mit jeder der genannten leitfähigen Signaleinrichtungen an verschiedenen Stellen entlang eines Abschnitts dieser Signaleinrichtung mehrere Signalpfade verbunden sind, wobei jeder der genannten Signalpfade mit einem entsprechenden der genannten Knotenpunkte verbunden werden kann; und
wobei jede der leitfähigen Signaleinrichtungen (43) ein oder mehrere zugehörige Kontaktstellen hat, um Signale dorthin zu liefern oder von dort zu empfangen, wobei diese Signale von den jeweiligen genannten Signalpfaden eingesammelt bzw. an sie verteilt werden;
**dadurch gekennzeichnet, daß** es sich bei den Kontaktstellen um Bondkontaktstellen handelt, daß die Bondkontaktstellen mit den leitfähigen Signaleinrichtungen selektiv verbunden werden können, und
daß die leitfahigen Signaleinrichtungen (43) in einem Gitter angeordnet sind.

2. Der integrierte Schaltkreis nach Anspruch 1, wobei der genannte integrierte Schaltkreis folgendes enthält:
einen Abtastpfad, der mit der leitfähigen Signaleinrichtung (43) oder jeder der leitfähigen Signaleinrichtungen (43) verbunden ist, um Signale, die von den genannten jeweiligen Signalpfaden eingesammelt bzw. dorthin verteilt wurden, von dort zu empfangen oder dorthin zu liefern.

3. Der integrierte Schaltkreis nach Anspruch 1 oder Anspruch 2,
wobei die leitfähige Signaleinrichtung (43) oder jede der leitfähigen Signaleinrichtungen (43) sich über den integrierten Schaltkreis in einer allgemein geraden Richtung zwischen einem zugehörigen Paar von Bondkontaktstellen erstreckt.

4. Der integrierte Schaltkreis nach Anspruch 3,
wobei sich ein Paar der leitfähigen Signaleinrichtungen über den integrierten Schaltkreis in einer allgemein geraden Richtung zwischen einem speziellen Paar von zugehörigen Bondkontaktstellen erstreckt.

5. Der integrierte Schaltkreis nach Anspruch 4,
wobei die leitfähigen Signaleinrichtungen (43) jedes Paares an gegenüberliegenden Enden mit jeweils anderen Bondkontaktstellen des zugehörigen Paars von Bondkontaktstellen, zwischen denen sich die leitfähigen Signaleinrichtungen erstrecken, selektiv verbunden werden können.

6. Der integrierte Schaltkreis nach einem der Ansprüche 3 bis 5,
wobei die leitfähigen Signaleinrichtungen zwei Gruppen enthalten, wobei sich diejenigen innerhalb einer dieser Gruppen allgemein parallel zueinander erstrecken.

7. Der integrierte Schaltkreis nach einem der vorhergegangenen Ansprüche, wobei er ein oder mehrere Paare von weiteren Bondkontaktstellen (V+, V-, TDO, TMS, TDI, TCK) enthält, die nicht mit den genannten leitfähigen Signaleinrichtungen verbunden werden können, wobei die Bondkontaktstellen von diesem Paar oder jedem dieser Paare bezüglich des Gitters einander gegenüberliegen und sich an den Enden einer geometrischen Linie befinden, die parallel zu einem der genannten leitfähigen Signaleinrichtungen verläuft.

8. Der integrierte Schaltkreis nach Anspruch 7,
wobei die genannten weiteren Bondkontaktstellen eine Bondkontaktstelle für die Stromversorgung enthalten.

9. Der integrierte Schaltkreis nach Anspruch 7 oder Anspruch 8,
wobei die genannten weiteren Bondkontaktstellen eine Bondkontaktstelle enthalten, die zum Anschluß einer externen Abtast-Teststeuerungseinrichtung dient.

10. Der integrierte Schaltkreis nach einem der vorhergegangenen Ansprüche,
wobei die leitfähigen Signaleinrichtungen (43) einen leitfähigen Signalsammler enthalten.

11. Der integrierte Schaltkreis nach einem der vorhergegangenen Ansprüche,
wobei die leitfähigen Signaleinrichtungen (43) einen leitfähigen Signalverteiler enthalten.

12. Der integrierte Schaltkreis nach Anspruch 10 und Anspruch 11, wenn diese sich auf Anspruch 2 beziehen, wobei die vielen Signalpfade folgendes umfassen:
eine erste Gruppe von Signalpfaden, die mit dem leitfähigen Signalsammler verbunden ist, wobei jeder dieser Signalpfade aus der genannten ersten Gruppe mit einem jeweils anderen der genannten Knoten aus einer ersten Gruppe verbunden werden kann und wobei eine oder mehrere der Bondkontaktstellen mit dem leitfähigen Signalsammler verbunden sind, um von dort Signale zu empfangen, die von der genannten ersten Gruppe von Signalpfaden eingesammelt wurden;
eine zweite Gruppe von Signalpfaden, die mit dem leitfähigen Signalverteiler verbunden ist, und wobei der genannte Abtastpfad an diesen leitfähigen Signalverteiler angekoppelt ist, um dorthin Signale zu liefern, die an die genannte zweite Gruppe von Signalpfaden verteilt werden sollen.

13. Der integrierte Schaltkreis nach Anspruch 10 und Anspruch 11, wenn diese sich auf Anspruch 2 beziehen,
wobei die genannten vielen Signalpfade folgendes umfassen:
eine erste Gruppe von Signalpfaden, die mit dem leitfähigen Signalsammler verbunden ist, wobei jeder dieser Signalpfade von der genannten ersten Gruppe mit einem jeweils anderen der genannten Knoten aus einer ersten Gruppe verbunden werden kann und wobei ein Abtastpfad an den leitfähigen Signalsammler angekoppelt ist, um von dort Signale zu empfangen, die von der genannten ersten Gruppe von Signalpfaden eingesammelt wurden;
eine zweite Gruppe von Signalpfaden, die mit dem leitfähigen Signalverteiler verbunden ist, wobei jeder dieser Signalpfade von der genannten zweiten Gruppe mit einem jeweils anderen der Knoten aus einer zweiten Gruppe verbunden werden kann und wobei eine Bondkontaktstelle an den leitfähigen Signalverteiler angekoppelt ist, um dorthin Signale zu liefern, die an die genannte zweite Gruppe von Signalpfaden verteilt werden sollen.

## Revendications

1. Circuit intégré, comprenant :
des circuits fonctionnels pour l'exécution de fonctions normales du circuit intégré, incluant une pluralité de noeuds répartis sur tout le circuit intégré ;
une pluralité de moyens (43) de signaux de conduction s'étendant à travers le circuit intégré ;
chacun desdits moyens de signaux de conduction ayant une pluralité de chemins de signaux connectés à celui-ci en des emplacements respectifs le long de celui-ci, chaque dit chemin de signaux pouvant se connecter à un respectif desdits noeuds ; et
chacun des moyens (43) de signaux de conduction ayant une ou plusieurs plaquettes pour lui fournir ou en recevoir des signaux respectivement collectés ou distribués par lesdits chemins de signaux ;
**caractérisé en ce que** les plaquettes sont des plaquettes collées, **en ce que** les plaquettes collées peuvent sélectivement se connecter aux moyens de signaux de conduction, et
**en ce que** les moyens (43) de signaux de conduction sont disposés en grille.

2. Circuit intégré selon la revendication 1, dans lequel ledit circuit intégré comprend : un chemin d'analyse couplé au moyen ou à chaque moyen (43) de signaux de conduction pour en recevoir ou lui fournir des signaux respectivement collectés ou distribués par lesdits chemins de signaux.

3. Circuit intégré selon la revendication 1 ou la revendication 2, dans lequel le moyen ou chaque moyen (43) de signaux de conduction s'étend à travers le circuit intégré dans une direction généralement linéaire entre une paire associée de plaquettes collées.

4. Circuit intégré selon la revendication 3, dans lequel une paire de moyens de signaux de conduction s'étend à travers le circuit intégré dans une direction généralement linéaire entre une paire particulière de plaquettes collées associées.

5. Circuit intégré selon la revendication 4, dans lequel les moyens (43) de signaux de conduction de chaque paire peuvent sélectivement se connecter aux extrémités opposées de l'une respective de la paire associée de plaquettes collées entre laquelle s'étendent les moyens de signaux de conduction.

6. Circuit intégré selon l'une quelconque des revendications 3 à 5, dans lequel les moyens de signaux de conduction comprennent deux ensembles, ces moyens de signaux de conduction s'étendant généralement parallèlement l'un par rapport à l'autre à l'intérieur de chacun de ces ensembles.

7. Circuit intégré selon l'une quelconque des revendications précédentes comprenant une ou plusieurs paires de plaquettes collées supplémentaires (V+, V-, TDO, TMS, TDI, TCK) ne pouvant se connecter auxdits moyens de signaux de conduction, les plaquettes collées de cette paire ou de chacune de ces paires étant placées l'une en face de l'autre par rapport à la grille et aux extrémités d'une ligne géométrique parallèle à l'un desdits moyens de signaux de conduction.

8. Circuit intégré selon la revendication 7, dans lequel lesdites plaquettes collées supplémentaires comprennent une plaquette collée d'alimentation.

9. Circuit intégré selon la revendication 7 ou la revendication 8, dans lequel lesdites plaquettes collées supplémentaires comprennent une plaquette collée qui est pour la connexion à un circuit de commande d'essai d'analyse externe.

10. Circuit intégré selon l'une quelconque des revendications précédentes, dans lequel les moyens (43) de signaux de conduction comprennent un collecteur de signaux de conduction.

11. Circuit intégré selon l'une quelconque des revendications précédentes, dans lequel les moyens (43) de signaux de conduction comprennent un distributeur de signaux de conduction.

12. Circuit intégré selon la revendication 10 et la revendication 11, si dépendantes de la revendication 2, dans lequel la pluralité de chemins de signaux comprennent :
un premier groupe de chemins de signaux connecté audit collecteur de signaux de conduction, chaque dit trajet de signaux dudit premier groupe pouvant se connecter à l'un respectif d'un premier groupe desdits noeuds et dans lequel ladite ou lesdites plaquettes collées sont couplées audit collecteur de signaux de conduction pour en recevoir des signaux collectés par ledit premier groupe de chemins de signaux ;
un deuxième groupe de chemins de signaux connecté audit distributeur de signaux de conduction, et ledit trajet d'analyse couplé audit distributeur de signaux de conduction pour lui fournir des signaux à distribuer audit deuxième groupe de chemins de signaux.

13. Circuit intégré selon la revendication 10 et la revendication 11, si dépendantes de la revendication 2, dans lequel ladite pluralité de chemins de signaux comprennent :
un premier groupe de chemins de signaux connecté audit collecteur de signaux de conduction, chaque dit trajet de signaux dudit premier groupe pouvant se connecter à l'un respectif d'un premier groupe desdits noeuds et dans lequel un chemin d'analyse est couplé audit collecteur de signaux de conduction pour en recevoir des signaux collectés par ledit premier groupe de chemins de signaux ;
un deuxième groupe de chemins de signaux connectés audit distributeur de signaux de conduction, chaque dit chemin de signaux dudit deuxième groupe pouvant se connecter à l'un respectif d'un deuxième groupe desdits noeuds et dans lequel une plaquette collée est couplée audit distributeur collecteur de signaux pour lui fournir des signaux à distribuer audit deuxième groupe de chemins de signaux.
